# EUROPEAN PATENT SPECIFICATION

(11) **EP 1 630 606 B1**
(45) Date of publication and mention of the grant of the patent: **13.08.2008**
(21) Application number: 04746476.3
(22) Date of filing: 25.06.2004
(51) Int. Cl.: G03F 7/039, G03F 7/004, G03F 7/00

(54) **POSITIVE PHOTOSENSITIVE COMPOSITION**
POSITIVE LICHTEMPFINDLICHE ZUSAMMENSETZUNG
COMPOSITION PHOTOSENSIBLE POSITIVE

(30) Priority: 30.06.2003 JP 2003189013; 03.07.2003 JP 2003190885
(43) Date of publication of application: 01.03.2006
(73) Proprietor: THINK LABORATORY CO., LTD., Chiba-ken, 227-0861 (JP)
(72) Inventor: SATO, Tsutomu, THINK LABORATORY CO., LTD., Kashiwa-shi, Chiba 2778525 (JP)
(74) Representative: Grünecker, Kinkeldey, Stockmair & Schwanhäusser Anwaltssozietät
(86) International application number: PCT/JP2004/009007
(87) International publication number: WO 2005/001576

(56) References cited:
- JP-A- 10 282 643
- JP-A- 11 506 550
- JP-A- 2001 022 059
- JP-A- 2001 181 221
- JP-A- 2002 023 364
- JP-A- 2002 131 893
- JP-A- 2002 189 294
- JP-A- 2002 214 785
- JP-A- 2002 303 983
- JP-A- 2003 345 017
- US-A1- 2003 003 406

## Description

### Technical Field:

The present invention relates to a positive photosensitive composition, and, particularly, to an alkali-soluble positive photosensitive composition having sensitivity to an infrared wavelength region laser so that when exposed to the laser light having a wavelength of 700 to 1,100 nm, the sensitized portion becomes soluble in an alkali developer. The positive photosensitive composition according to the present invention may be effectively used in photofabrication and especially used in the field of photo-fabrication applied to the production of printing plates, electronic parts, precision mechanical equipment parts, members relevant to prevention of forgery or the like.

### Background Art:

A conventional positive photolithographic printing plate contains a novolak resin and an o-quinonediazide compound which is a substance sensitive to white light. It is known that as shown in the following formula (I), due to photo-decomposition (chemical change), the o-quinonediazide compound causes an Arndt-Eistert type rearrangement to form a ketene structure, thereby generating a five membered ring carboxylic acid in the presence of water, and as shown in the following formula (II), ketene present in the upper part of the photosensitive layer of the exposed portion is reacted with naphthoquinonediazide present in the lower part of the photosensitive layer to form lactone, at development by an alkaline aqueous solution, this lactone ring opens to form sodium carboxylate, and also, since the coexisting novolak resin is alkali-soluble, the sodium carboxylate elutes together with the novolak resin, while the photosensitive layer of the unexposed portion enters into a coupling reaction with the coexisting novolak resin by the aid of the alkaline solution used at development as shown in the following formula (III), with the result that it becomes sparingly soluble in alkali and is left as a resist image (see Non-patent document 1). When the σ quinonediazide compound is contained, wide latitude of development is obtained.

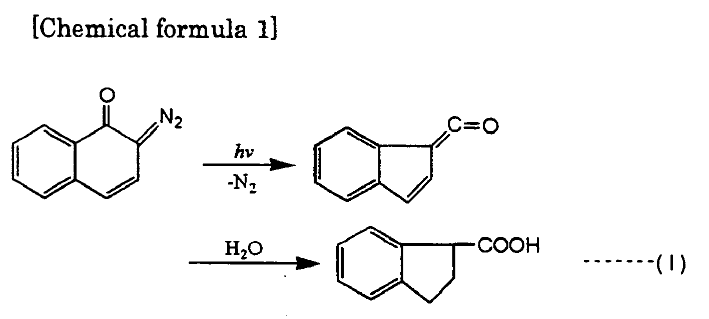

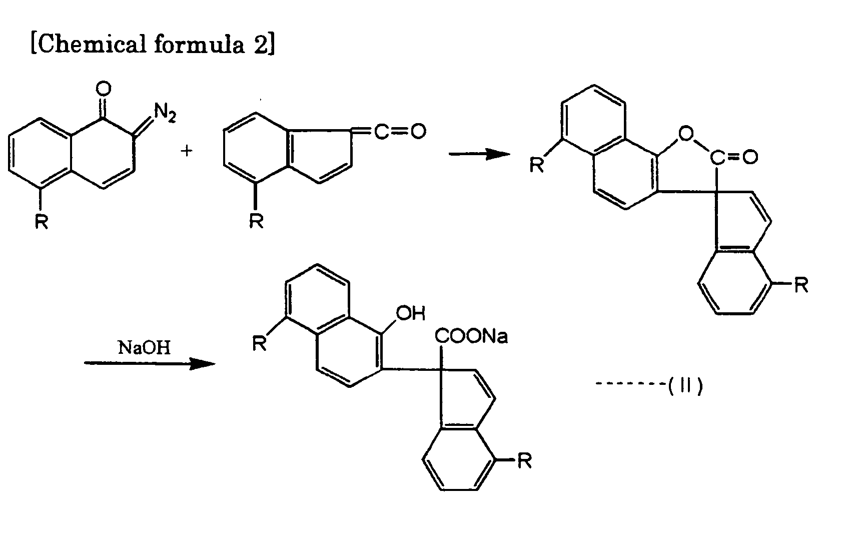

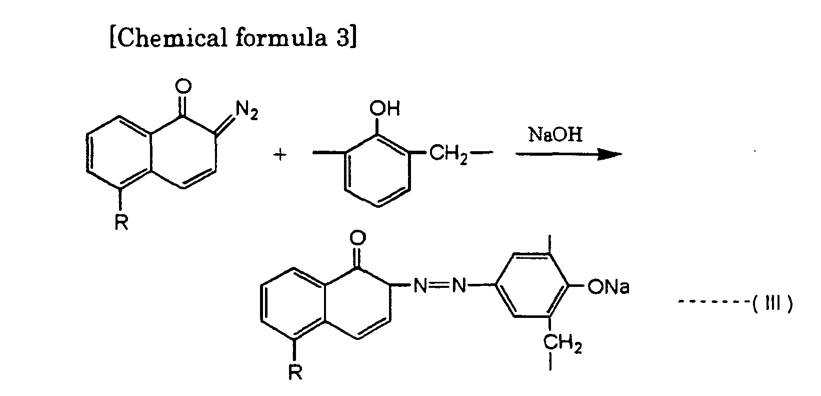

In the present specification, the term "have latitude of development" means such a condition that plate-making can be made stably under the situation that the film thickness is not changed in the development (loss of the film thickness is little), the area of the dots is not changed for a prescribed developing time and a phenomenon that a residue (what is left) suddenly appears does not occur.

In the meantime, a positive photosensitive composition utilizing a change other than chemical changes is invented to accomplish plate-making under a white lamp, and a method is studied out in which a positive image is printed by an infrared wavelength region laser to increase the solubility of the exposed portion in a developing solution, thereby forming a positive image. This method is put into practice in offset-plate-making and flexo-plate-making (see, for example, Patent documents 1 to 10).

The positive photosensitive lithographic printing plates described in the above each reference contain a substance, such as an infrared ray absorbing dye, that absorbs infrared light to convert it into heat and an alkali-soluble resin such as a novolak resin as major components of the photosensitive layer and a physical change such as the conformation change of the resin is caused by heat generated by exposure to light from an infrared laser to thereby increase the solubility of these components in a developing solution.

However, the positive photosensitive lithographic printing plate, which contains no o-quinonediazide compound and is operated to increase the solubility by printing a positive image by laser light of an infrared wavelength region to cause a physical change such as the conformation change of the resin, needs burning (heating operation) after coating at present. Under present situation, even if the burning is conducted, a difference in dissolution rate between an exposed portion and an unexposed portion is still small, the fundamental performances of printing plates such as sensitivity and latitude of development are inferior and it is difficult to satisfy developing stability when increasing the number of sheets to be developed.

On the contrary, the situation is utterly different in the case of gravure-plate-making. In Japan where gravure-plate-making/printing is most widely spread, a gravure-plate-making method in which gravure-plate-making can be conducted using a positive thermal resist which may be developed under no heating after the resist is applied, has not been carried out at all and nowhere found in Patent documents and experimental documents.

Conditionally, a gravure-plate-making process of a plate-making roll by an etching method/laser-plate-making method involves, for example, following steps: loading/degreasing/washing with water/washing with an acid/washing with water/Ballard treatment/washing with water/Ballard copper plating/washing with water/grinding using an abrasive/washing with water/coating with a photosensitive agent/coating with an antioxidant/printing of an image by an exposure apparatus using an infrared laser/development/washing with water/etching/washing with water/peeling of a resist/washing with water/chrome plating/washing with water/grinding/washing with water/unloading. Examples of technical documents disclosing the gravure-plate-making process of a plate-making roll by the etching method/laser-plate-making method may include Patent documents 11 to 29.

In all the gravure-plate-making processes described in the above documents, a photosensitive film comprising a negative photosensitive composition is formed by application but a photosensitive film comprising a positive photosensitive composition is not formed by application. In conventional etching methods, a negative photosensitive film is applied to a plate-making roll and dried up at room temperature to form a negative photosensitive film, which is then printed by an argon ion laser. However, a method in which a positive photosensitive film is formed on the plate-making roll to print a positive photosensitive film image by laser light having infrared wavelengths is not carried out.

A high power semiconductor laser head manufactured by CreoScitex Co., Ltd. in Canada is a type emitting a laser having a wavelength falling in the infrared region, is mounted on an offset printer, where a positive photosensitive composition is irradiated with the laser light and is probably well developed, and is thus put into practical use world-wide.

If the beam diameter of argon ion laser light is the same in size as the beam diameter of laser light having a wavelength of 700 to 1,100 nm, laser resolution is higher and process time can be substantially more reduced in the case of a positive type than in the case of a negative type.

Moreover, the sharpness of a pattern is better in the case of printing a positive image on a photosensitive film of a positive photosensitive composition by a laser having a wavelength falling in the infrared region than in the case of printing a negative image on a photosensitive film of a negative photosensitive composition by an argon ion laser. This is considered to be due to a difference in the sharpness of a pattern caused by a difference between a positive photosensitive composition and a negative photosensitive composition.

The reason why a positive photosensitive composition has not been used in gravure-print-making although it is used in offset-plate-making and flexo-plate-making in the prior art is that a negative photosensitive agent can be used in gravure-plate-making. Since a negative photosensitive agent is used to secure the degree of polymerization of a resin of the exposed portion by irradiating the resin with ultraviolet rays, a necessary and sufficient latitude of development can be ensured even if any material is used as the material to be coated.

In the meantime, there has been no positive photosensitive composition having latitude of development that can be satisfied in relation to copper sulfate plating of a gravure-printing roll. This is particularly because there has been no photosensitive composition that is not processed by burning after applied. There is no condition allowing the formation of a coat if a positive photosensitive composition which is used in offset-plate-making or flexo-plate-making is applied to gravure-plate-making roll. In many cases, a coat of a positive photosensitive composition to gravure-plate-making roll is flowed away by the alkali developer completely. Even if burning is conducted after coating, the same results will be obtained.

A high resolution gravure-plate-making system using a semiconductor laser or YAG laser which outputs high power laser light having a wavelength falling in the infrared region and using a positive photosensitive film has been desired to be put into practice from the viewpoint of downsizing of a device, environmental light during plate-making work, resolution and the sharpness of a pattern as compared with the case of using an argon ion laser.
- Patent document 1:: JP-A No. 10-268512
- Patent document 2:: JP-A No. 11-194504
- Patent document 3:: JP-A No. 11-223936
- Patent document 4:: JP-A No. 11-84657
- Patent document 5:: JP-A No. 11-174681
- Patent document 6:: JP-A No. 11-231515
- Patent document 7:: WO97/39894
- Patent document 8:: WO98/4250
- Patent document 9:: JP-A No. 2002-189293
- Patent document 10:: JP-A No. 2002-189294
- Patent document 11:: JP-A No. 10-193551
- Patent document 12:: JP-A No. 10-193552
- Patent document 13:: JP-A No. 2000-062342
- Patent document 14:: JP-A No. 2000-062343
- Patent document 15:: JP-A No. 2000-062344
- Patent document 16:: JP-A No. 2001-179923
- Patent document 17:: JP-A No. 2001-179924
- Patent document 18:: JP-A No. 2001-187440
- Patent document 19:: JP-A No. 2001-187441
- Patent document 20:: JP-A No. 2001-191475
- Patent document 21:: JP-A No. 2001-191476
- Patent document 22:: JP-A No. 2001-260304
- Patent document 23:: JP-A No. 2002-127369
- Patent document 24:: JP-A No. 2002-187249
- Patent document 25:: JP-A No. 2002-187250
- Patent document 26:: JP-A No. 2002-200728
- Patent document 27:: JP-A No. 2002-200729
- Patent document 28:: JP-A No. 2002-307640
- Patent document 29:: JP-A No. 2002-307641
- Patent document 30:: JP-B No. 07-109511
- Patent document 31:: JP-A No. 2004-133025
- Patent document 32:: JP-B No. 47-25470
- Patent document 33:: JP-B No. 48-85679
- Patent document 34:: JP-B No. 51-21572
- Non-patent document: 1: Gentaro Nagamatsu and Hideo Inui, "Photo-sensitive polymer", Kodansha, Sept. 1, 1978, p. 104-122.

### Disclosure of the Invention:

### Problems to be solved by the Invention

The present inventor, in view of the above situation, started developing a positive photosensitive composition having necessary and sufficient latitude of development without burning after coating as to the relation of a gravure-printing roll to copper sulfate plating.

Then, as to an etching method as one of plate-making methods of a gravure printing roll, a test was made where an undiluted solution of a positive photosensitive composition combined with a novolak resin and a cyanine dye was prepared and a positive photosensitive agent prepared by diluting the undiluted solution with a solvent was applied to the copper sulfate plating surface of a gravure-plate-making roll. In the application of the positive photosensitive agent, a photosensitive film coater (manufactured by Think Laboratory Co., Ltd.) according to Patent document 30 was used. Then, a laser having a wavelength falling in the infrared region was applied to the applied photosensitive agent by an infrared laser exposure apparatus (manufactured by Think Laboratory Co., Ltd.) mounted with a high-power semiconductor laser head manufactured by CreoScitex Co., Ltd. to print a positive image and then the positive image was developed. As a result, the photosensitive film was entirely peeled off and therefore any satisfactory resist image was not obtained.

The evaluation of the coating produced by the photosensitive film coater according to Patent document 30 was made. As a result, it was found that the photosensitive film coating apparatus used a spiral scan system which was a contact coating system where the coating roll was dipped in a photosensitive agent filled in a tank to apply the photosensitive agent many times to the surface to be coated and it was therefore considered that air was intermingled in the photosensitive film. Also, since the tank had an open structure, a solvent contained in the photosensitive agent reserved in the tank was vaporized to take latent heat of vaporization away, so that the coating roll was cooled, resulting in coating accompanied by blushing. Also, it was found that the concentration of a solvent was reduced continuously so that the viscosity of the photosensitive agent was raised gradually, which made it impossible to coat in a uniform thickness. As a consequence, it was concluded that even if a negative photosensitive agent was appropriately applied to form the photosensitive film by the photosensitive film coater according to Patent document 30, this coater was quite unfit to the positive photosensitive film.

In light of this, in place of the photosensitive film coater according to Patent document 30, there was developed a photosensitive film coater where the photosensitive agent can be coated to the plate-making roll in a closed state in which the solvent in the photosensitive agent filled in the tank was not vaporized and also in the condition that the photosensitive agent was not in contact with the roll and the coating accompanied by the blushing is avoidable.

To explain the schematic structure of the photosensitive film coater, a method of applying a positive photosensitive agent to the plate-making roll to form a film involves a process in which the upper end of a vertical tube for discharging a photosensitive agent is brought into close contact with the underside of one end of a plate-making roll both ends of which are chucked horizontally and which is rotated, the photosensitive agent is supplied in a manner that it is overflowed from the photosensitive agent discharge tube with being slightly above the upper end thereof, the photosensitive agent discharge tube is moved from the one end to other end of the plate-making roll to thereby coat the plate-making roll with the coating solution by a spiral scan system and the rotation of the roll is continued until the coating film is naturally dried.

Then, the studies were continued, but strong adhesion of a positive photosensitive composition to a copper sulfate plating surface was not obtained and when the coating film was developed, it was flowed away immediately by an alkali developer whether it is a line image portion or a non-line image portion. It was therefore considered that it was unavoidable to impart adhesion to the coating film by carrying out burning where the coating surface was processed under heating at high temperatures after the coating film was formed.

The reason of the idea as to the necessity of burning was as follows. It was considered that the very inferior adhesiveness of the positive photosensitive composition to the copper sulfate plating surface caused the condition under which no film was formed and that if burning was carried out after the film was formed, the hydrogen bond of an alkali-soluble organic high molecular substance having a phenolic hydroxyl group may be strengthened to improve the adhesion.

For the moment, the studies were continued on the premise that burning was carried out. When the above-produced positive photosensitive composition compounded of a novolak resin and a cyanine dye was applied to the plate-making roll to carry out burning for 30 minutes such that the temperature of the coating surface was 60°C, followed by exposing using a laser and developing, resulting in inferior development.

For this, burning was carried out for 30 minutes such that the temperature of the coating surface was 130°C. Even though such burning was carried out, such a poor development arose that the entire surface including a non-line image portion was broken away. It was concluded that the reason why such a poor development arose even if burning was carried out was caused by excessively low adhesion of the positive photosensitive composition to copper sulfate plating.

Then, a silane coupling agent was compounded as an auxiliary improving adhesion in the positive photosensitive composition to increase the adhesion of the photosensitive film, with the result that exposure and development were carried out somewhat satisfactorily. Specifically, for example, a plate-making roll of φ 200 mm was rotated at a speed as low as 25 r.p.m. to apply a positive photosensitive agent. The roll was allowed to stand for 5 minutes under a natural drying condition with continuing the rotation such that dripping of the solution was prevented, to vaporize a solvent thereby drying the photosensitive agent to the extent that no dripping of the solution arose to obtain a photosensitive film. When the produced photosensitive film was set and then subjected to burning carried out at 130°C for 30 minutes, the concentration of a residual solvent was less than 2% and an image could be printed by a laser, making it possible to develop.

However, the adhesion to the film was not said to be the best and the exposure and development were within a somewhat good range. Also, when the temperature of the film surface was 130°C, 100 minutes or more time was required for burning and the successive cooling and a large amount of heat energy was therefore necessary, leading to high running costs and it was thus found that this method was scarcely put into practice. Also, when the temperature of the film surface was 130°C, the hydrogen bond of the alkali-soluble organic high molecular substance having a phenolic hydroxyl group was strengthened, which not only made it difficult to develop but also caused a cyanine dye to be denatured, leading to reduced sensitivity, which was confirmed by low sharpness of a pattern.

It was found from careful observation of the resist image that many pinholes were generated. The generation of such pinholes was not observed in a negative resist image. This reason was considered to be that only washing with water after precision abrading using a grinding stone failed to flow away an abrasive powder stuck to the plate-making roll from the roll, dusts were stuck to the plate-making roll while the plate-making roll was conveyed if a plate-making room was not a highly clean room and a positive resist image was very more sensitive to film-forming conditions than a negative resist image. Then, various studies were made and as a result, the plate-making roll was sufficiently wiped away using a wiping cloth before the photosensitive agent was applied to the plate-making roll, with the result that the generation of pinholes was suppressed.

In the meantime, there are rolls made of aluminum as a base material and those made of iron as a base material as a gravure-plate-making roll. Also, these rolls are different in roll diameter and the difference in roll diameter all leads to a difference in the thickness of these rolls. Therefore, even if the rolls are heated for the same time and the heat is conducted to the roll base materials, each temperature of film surface was not always heated to 130°C but to variously different temperatures, giving rise to the dispersion of temperature because of the difference in specific heat capacity between these rolls. It was therefore considered to be important to eliminate the problem concerning the specific heat capacity by dropping the temperature. It was considered that the burning for substantially reducing solvent concentration could be achieved by selecting a composition having good solvent-separating ability even if the burning was carried out at a temperature of film surface by far lower than 130°C.

When tests in which heating time was shortened step by step was made and the burning was carried out at temperatures of film surface dropped to 80°C to 100°C for 50 minutes, the concentration of a solvent was confirmed to be 6% or less; however, the development was inferior. This was given a conclusion that necessary and sufficient adhesion could not be obtained by the above silane coupling agent.

Then, imidazole (including imidazole silane) which was a hardening promoter was compounded as an adhesive agent in place of the silane coupling agent. However, the positive photosensitive composition containing imidazole has no particular difference from the composition containing the silane coupling agent and the burning temperature of the film surface was also the same as in the case of the silane coupling agent.

In succession, the following experiment was conducted. Specifically, various adhesives were each added to an undiluted solution of a positive photosensitive composition containing an alkali-soluble organic high molecular substance having a phenolic hydroxyl group and a photo-thermal conversion material which absorbs infrared rays from an exposure light source to convert them into heat, to form a photosensitive film on a copper sulfate plating roll at 25°C. A test image was exposed to light by using the aforementioned infrared laser exposure apparatus (manufactured by Think Laboratory Co., Ltd.) and then developed. As a consequence, in the case of a photosensitive film of a positive photosensitive composition compounded of a titanium organic compound, the burning temperature could be outstandingly dropped (see Patent document 31).

In the case of a photosensitive film of the positive photosensitive composition compounded of a titanium organic compound, the film was well formed even when the burning temperature was 46°C and the film had good sensitivity, making it easy to develop. However, in a test in which no burning treatment was performed, only an unsatisfactory film could be formed, resulting in inferior development.

Although the burning temperature could be dropped to the vicinity of 50°C, the necessity of burning had disadvantages in that it was necessary to cool after burning, it took time and energy to carry out burning and the successive cooling and the equipment line was longer by the length of the burning equipment, increasing equipment cost and running cost. As was expected, development of a process in which burning was unnecessary was thought to be the problem to be solved.

If burning is performed, it takes 30 to 60 minutes to raise the temperature of the roll to a necessary temperature and it takes 50 to 100 minutes or more to cool the roll to room temperature because the roll is increased in heat load unlike a thin plate material. Also, these times differ depending on the size of the roll and it is therefore impossible to control the temperature uniformly. Also, the practice of the burning causes a cyanine dye to be denatured, leading to reduced sensitivity and low sharpness of a pattern, and also at the time of development causes the resist to be thin which is a cause of the retardation of an outline and the generation of pinholes. It has been therefore desired to develop a positive photosensitive film free from the necessity of burning.

Many tests were repeated and as a result, it was clarified that if the total concentration of residual solvents such as MEK, IPA and PM was high when a film was formed, an image was not printed by a laser (this means that the test failed in its purpose of cutting the main chain or side chain part of the photosensitive film-forming resin of an exposed portion to form low molecules more increased in alkali-solubility and of forming a latent image put into the state where the photosensitive layer was properly scattered).

The concentrations of residual solvents when the aforementioned positive photosensitive agent compounded of a titanium organic compound was applied to a copper sulfate plating plate and dried at a room temperature of 25°C in a natural drying condition without any air-blowing for 15 minutes and for 25 hours were 11% and 9% respectively. It was found that the concentration of solvents was dropped only to 7% from the result of measurement 10 minutes after the positive photosensitive agent was applied to the plate-making roll rotated at 45 r.p.m. Therefore, it was clarified that in order to remake an undiluted solution of a positive photosensitive film necessitating no burning by compounding an auxiliary strengthening adhesion in a positive photosensitive agent to reform and to confirm the result of the reforming by exposure and development, it was necessary to device technologies that could outstandingly reduce the concentration of residual solvents in advance at the same time.

In this situation, the inventor, for the first time, adopted a developing theme concerning practical use of a positive photosensitive film necessitating no burning wherein the development of film-drying techniques that could substantially decrease the concentration of residual solvents in a short time with ease by other means except for burning after forming the film was discriminated conceptually from the development of a positive photosensitive film in which the adhesion of the positive photosensitive film itself could be largely improved by adding an auxiliary strengthening adhesion and a good latitude of development could be realized, to continue the studies to solve the former theme first.

The inventor thought about the vaporization of solvents from the coating film. The coating film touched air and was dried from the surface, increasing in hardness and, the tissue was tightened and it was therefore considered that the diffusibility of solvents present in the internal layer would be more reduced as time passed and the surface was more dried. On the other hand, it was thought that the degree of vaporization of solvents from the coating film differed depending on the atmospheric pressure, and when the pressure was negative, the degree of vaporization of solvents from the coating film was increased and residual solvents could be reduced efficiently. However, the roll coated could not be placed in a chamber evacuated using a vacuum pump. Here, the inventor made the plate-making roll rotate at a high speed after dripping of a liquid from the coating film was not seen, to find that the concentration of residual solvents was dropped to 3% or less in a short time.

Based on this finding, the plate-making roll was rotated at a predetermined low speed with the both ends being supported horizontally in a photosensitive film coater according to Patent document 30. A test sensitizing solution was applied uniformly to the plate-making roll in a spiral scan system or a non-contact coating system. Then, the rotation was continued to vaporize a solvent thereby drying the solvents to the extent that no dripping of a liquid arose to obtain a photosensitive film, which was then set to the coater. As technologies that made it possible to decrease the concentration of solvents substantially in a very short time even if the burning was not carried out, techniques were established in which the plate-making roll was rotated at a predetermined high speed for a predetermined time to effect centrifugal force on residual solvents in the film, thereby causing friction between the film surface and air, allowing the residual solvents in the film to be diffused and separated in the air, whereby a coating film was obtained which had a low concentration of residual solvents which concentration made it possible to develop image printing ability by a laser.

A test roll of φ 200 mm was coated uniformly with a sensitizing solution and rotated continuously at 25 r.p.m. for 5 minutes after the coating was finished. Then, the rotation was stopped to observe dripping of a liquid after of elapse of 5 minutes after the rotation was stopped. It was confirmed that the dripping of a liquid was not observed by naked eyes. Thereafter the test roll was rotated at 100 r.p.m. for 20 minutes and then stopped, to measure the concentration of residual solvents in the photosensitive film, to find that the concentration was 2.3%.

The technologies that could substantially reduce the concentration of solvents in a very short time without burning were developed. Then, studies were continued as to whether or not a positive photosensitive agent had latitude of development after various auxiliaries strengthening adhesion are added to carry out exposure and development.

As a consequence, when a cellulose derivative and at least one titanium organic compound selected from titanium alkoxide, titanium acylate and titanium chelate were added to an undiluted solution of a positive photosensitive composition containing an alkali-soluble organic high molecular substance having a phenolic hydroxyl group and a photo-thermal conversion material which absorbs infrared rays from an image exposure light source to convert them into heat, to make a test. As a result, if burning treatment was carried out, development was inferior whereas if burning treatment was not carried out, development was satisfactory and the best resist pattern was obtained. At this time, the room temperature was 25 to 27°C and the humidity was around 50 to 55%.

However, the test was made on a day under the condition that the maximum temperature in the daytime was 16°C and humidity was as very low as 21 to 23%, with the result that the photosensitive film was wholly fallen down when development was carried out. The positive photosensitive agent was known to have such humidity dependency that the blushing usually occurred under humidity as high as 60% or higher and no film could be therefore formed. However, it was clarified from the above results that, when the temperature was low and the humidity was very low, the adhesion of a positive photosensitive agent was not also developed. Incidentally, the reason why the blushing occurred and no film was therefore formed could not be clarified.

Then, a resin having latitude of development that became a base in place of the alkali-soluble organic high molecular substance having a phenolic hydroxyl group was investigated. A styrene/maleic acid half ester resin obtained by esterifying a styrene/maleic anhydride copolymer by an alcohol was used in place of the alkali-soluble organic high molecular substance having a phenolic hydroxyl group to make a positive photosensitive composition containing a photo-thermal conversion material which absorbs infrared rays from an image exposure light source to convert them into heat. A test in which the composition was applied to the roll, followed by carrying out exposure and development was carried out one after another and as a result, large latitude of development was obtained.

To state in more detail, in the condition that the temperature in a laboratory was 25°C and the humidity in the casing of the photosensitive film coater was changed to 25%, 30%, 55% or 60%, a plate-making roll of φ 200 mm on which copper sulfate was plated was rotated at a speed of 25 r.p.m. with both ends thereof being supported in the photosensitive film coater, to wipe the surface of the roll using a wiping cloth and to apply the above positive photosensitive agent so as to trace the wiped surface. Even after the application was finished, the roll was allowed to stand for 5 minutes under natural drying conditions with continuing the rotation such that dripping of a liquid was prevented, to form a film, then rotated at 100 r.p.m. for 10 minutes to reduce residual solvents and then stopped.

The plate-making rolls taken out of the photosensitive film coater were all glossy and there were obtained test rolls on which a very hard photosensitive film having very strong adhesiveness was formed by application. The film thickness of each resist was 3.5 to 3.8 µm. The concentration of residual solvents was measured, to find that each concentration of all test rolls was around 2.3%. Then, a test image was exposed to light (image line parts were exposed to light) from a laser in the infrared wavelength region by the infrared laser exposure apparatus (manufactured by Think Laboratory Co., Ltd.) and then developed by an alkali, with the result that the film was decreased including the elution of non-image line parts. However, in any case, an extremely sharp resist pattern free from any residue was obtained when the resist was dipped in an alkali developing solution for 60 to 70 seconds. Then, it was confirmed that a resist pattern obtained which was naturally dried with time after development was very hard. The film thickness of the resist after development was 1.8 to 2.5 µm. No generation of pinholes caused by a reduction in film was observed. Thus, the present invention was completed.

The present invention relates to a positive photosensitive composition which is sensitized when it is exposed to laser light having a wavelength of 700 to 1,100 nm, the sensitized portion being made soluble in an alkali developing solution. It is an object of the present invention to provide a positive photosensitive composition having the following characteristics: 1) when the composition is applied in an application working room in which the humidity is in a range from 25 to 60%, it is applied to a subject to be coated, the subsequent burning is not required, and necessary and sufficient adhesion to aluminum, of course and also to copper or copper sulfate plating which requires very stronger adhesion than aluminum is obtained, 2) good alkali development free from the generation of residues can be accomplished in a proper time of about 60 to 70 seconds and it is possible to develop even if the alkali strength of a developing solution is low, which makes easy to carry out working during development and to treat waste solutions, 3) no burning treatment is carried out and high sensitivity is therefore maintained, and the edge of a resist image has an outline cut sharply in accordance with the exposure irradiated pattern, making it possible to attain very good development, 4) a reduction in film thickness after development is small and the generation of pinholes caused by the film reduction is reduced, ensuring very good development, 5) a resist image is glossy, it is possible to attain a resist image having printing durability ensuring that several thousand sheets can be copied if it is subjected to printing as it is and the scratching resistance of the photosensitive film is improved in the handling before development after the photosensitive film is formed and 6) image printing by a laser and a latitude of development are superior.

### Means to solve the problem

In order to solve the above problem, A positive photosensitive composition of the present invention comprises (A) a high molecular substance having at least one carboxyl group in a molecule and (B) a photo-thermal conversion material that absorbs infrared rays from an image exposure light source and converts it to heat, wherein the high molecular substance (A) is a polymer represented by the following formula (1): 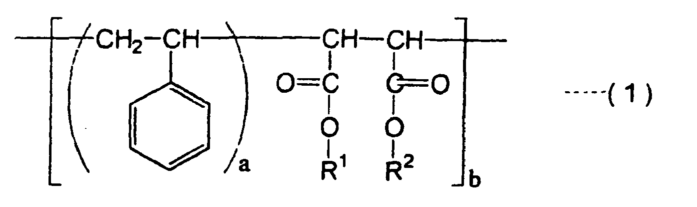 wherein each of "R¹" and "R² " independently represents a hydrogen atom or a substituted or unsubstituted alkyl group, "a" denotes an integer from 1 to 3 and "b" denotes an integer of 1 or more.
The high molecular substance (A) is preferably at least one polymer
compound selected from the group consisting of a polymer obtained from an unsaturated compound (a1) having at least one carboxyl group and/or carboxyanhydride group and a copolymer obtained from the unsaturated compound (a1) and a compound (a2) copolymerizable with the unsaturated compound.

The unsaturated compound (a1) is preferably at least one compound selected from the group consisting of maleic acid, (meth)acrylic acid and their derivatives. In the present invention, acryl and methacryl are collectively called (meth)acryl.

The high molecular substance (A) is preferably at least one polymer selected from the group consisting of a maleic acid polymer, a (meth)acrylic acid polymer and a styrene/maleic acid copolymer and their derivative.

The high molecular substance (A) is preferably a styrene/maleic acid copolymer obtained by reaction of a styrene/maleic anhydride copolymer with a compound having a hydroxyl group. The compound having a hydroxyl group is preferably an alcohol.

The high molecular substance (A) is preferably a copolymer represented by the following formula (1).

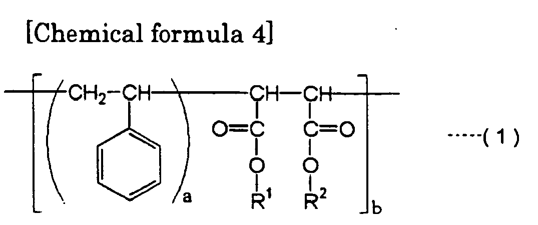

In the formula (1), each of "R¹" and "R²" independently represents a hydrogen atom or a substituted or unsubstituted alkyl group, "a" denotes an integer from 1 to 3 and "b" denotes an integer from 6 to 8.

The positive photosensitive composition of the present invention preferably further comprises (C) a dissolution inhibitor.

The dissolution inhibitor (C) is preferably a compound represented by the following chemical formula (2).

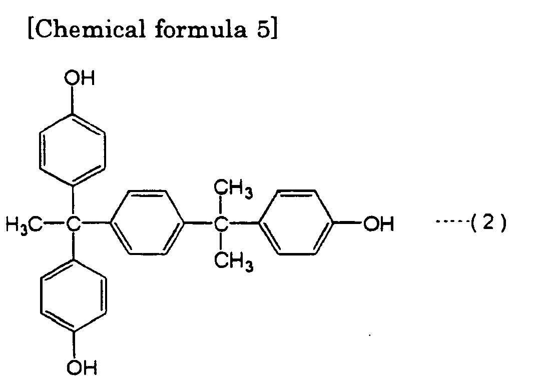

The photo-thermal conversion material (B) is preferably a compound represented by the following formula (3).

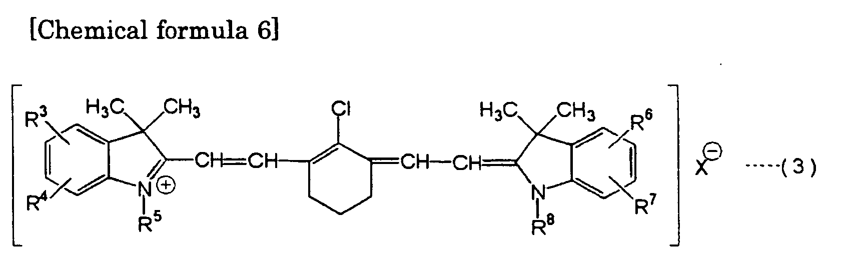

In the formula (3), each of "R³" to "R⁸" independently represents a hydrogen atom, an alkyl group having 1 to 3 carbon atoms or an alkoxyl group having 1 to 3 carbon atoms, "X" represents a halogen atom, ClO₄, BF₄, p-CH₃C₆H₄SO₃ or PF₆.

The photo-thermal conversion material (B) is preferably a compound represented by the following formula (4).

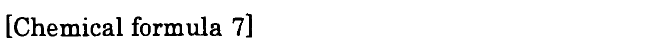

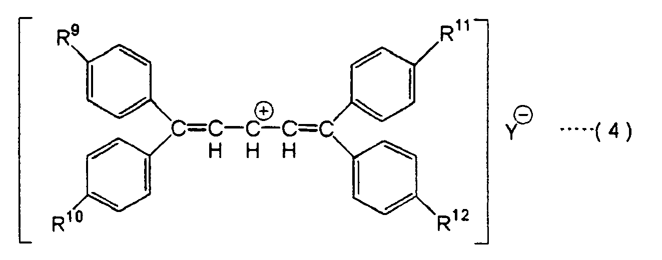

In the formula (4), each of "R⁹" to "R¹²" independently represents a hydrogen atom, a methoxyl group, -N(CH₃)₂ or -N(C₂H₅)₂ and "Y" represents C₄H₉-B(C₆H₅)₃, p-CH₃C₆H₄SO₃ or CF₃SO₃.

The positive photosensitive composition of the present invention preferably further comprises (D) a photo-acid generator. The photo-acid generator (D) is preferably a compound represented by the following formula (5).

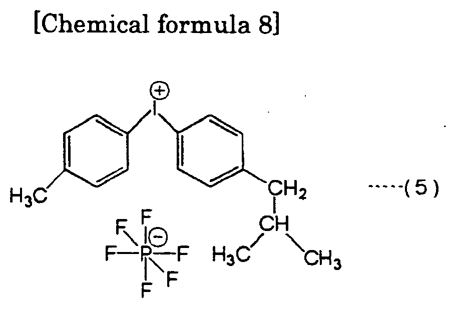

The positive photosensitive composition of the present invention preferably further comprises (E) at least one resin selected from the group consisting of (1) a vinylpyrrolidone/vinyl acetate copolymer, (2) a vinylpyrrolidone/dimethylaminoethyl methacrylate copolymer, (3) a vinylpyrrolidone/vinyl caprolactam/dimethylaminoethyl methacrylate copolymer, (4) a polyvinyl acetate, (5) a polyvinyl butyral, (6) a polyvinyl formal, (7) a terpene phenolic resin, (8) an alkylphenolic resin, (9) a melamine-formaldehyde resin and (10) a ketone resin.

The positive photosensitive composition of the present invention preferably further comprises (F) a triarylmethane dye.

A photo-fabrication method of the present invention comprises using the positive photosensitive composition of the present invention. The photo-fabrication method is preferably applied to production of a printing plate, an electronic component, a precision equipment component and a component relating to a counterfeit deterrence.

A plate-making method of the present invention comprises using the positive photosensitive composition of the present invention. Printing plates such as an intaglio (gravure), lithography, relief and mimeograph may be produced by the plate-making method of the present invention.

A general plate-making process of a gravure plate using the positive photosensitive composition of the present invention as a sensitizing solution is as follows.
1. Application of a sensitizing solution to a cylinder (dry film thickness: preferably 2 to 5 µm, the film is preferably thicker to reduce pinholes, but the film is preferably thinner because the amount of the solution to be used is reduced and the production cost is reduced that much) → 2. Drying (until touch dry: 15 minutes → until end: 15 to 20 minutes) → 3. Exposure (light source: semiconductor laser 830 nm, 220 mJ/cm²) → 4. Development (60 to 90 seconds/25°C) → 5. Washing with water (spray, 30 seconds) → 6. Etching (depth: 10 to 30 µm, etching: a solution of cupric chloride in water, conversion of copper: 60 g/L) → 7. Peeling of resist (peeling using an alkali) → 8. Washing with water → 9. Cr plating (chromic acid: 250 g/L, sulfuric acid: 2.5
g/L in waster) → 10. Washing with waster → 11. Printing.

A general plate-making process of a lithography (PS plate) using the positive photosensitive composition of the present invention as a sensitizing solution is as follows.
1. CTP (PS plate) (aluminum abrasion → application of a sensitizing solution → drying) → 2. Exposure (light source: semiconductor laser 830 nm, 220 mJ/cm²) → 3. Development → 4. Printing.

### Effect of the Invention

The positive photosensitive composition of the present invention is alkali-soluble positive photosensitive composition that is sensitized when exposed to laser light in the infrared wavelength region wherein the exposed portion becomes soluble in a developing solution. The composition has the following excellent effects.
(1) Necessary and sufficient adhesion to aluminum and copper as well as even to a less adhesive subject to be coated such as glossy and mirror-like plated copper can be obtained without burning. Also, even though burning is not carried out, a photosensitive film having the same glossiness as in the conventional case of carrying out burning can be obtained.
(2) Necessary and insufficient adhesion is obtained in the condition of humidity of 25 to 60%.
(3) Good alkali development is accomplished without any generation of residues in a proper time. Although the photosensitive layer components are not substantially changed chemically by exposure to light, all of the basic performances of a printing plate such as printing durability, sensitivity and latitude of development can be satisfied. Also, since a high molecular substance having carboxyl group is used, development can be carried if the strength of an alkali developing solution is low. Since development can be carried out at a pH range of developing solution from 10 to 12, the amount of carbonic acid gas dissolved in air is small and a reduction in the pH of an alkali developing solution with time is small that much. On the other hand, a developing solution for phenolic resin is reduced in pH immediately after the preparation of the developing solution by the effect of carbonic acid gas and development cannot be accomplished continuously if a buffer solution is not used as the developing solution. A developing solution that is not a buffer solution will be reduced in alkali concentration in 2 to 3 days at most. In such a situation, the composition is controlled more easily as to a reduction in alkali concentration than a phenolic resin that is developed by a developing solution at a pH of 13.0 or more. Also, the range of selection of the alkali developer is widened and at the same time, waste treatment is easy because the strength of an alkali waste solution is low. The preparation of the developing solution: means that an undiluted solution of a developing solution is diluted with water in a developing tank to form a developing solution.)
(4) Even if image exposure is carried out using an exposure energy lower than high exposure energy causing the generation of excess heat due to a photo-thermal conversion material in the photosensitive layer, a wide latitude of development can be adopted. Therefore, because the generation of scattering of the photosensitive layer is limited to a low level, the problem that the photosensitive layer is scattered (made abrasion) to contaminate the optical system of an exposure apparatus does not arise.
(5) No burning treatment is carried out, which ensures that high sensitivity is maintained and makes it possible to attain such good development that the edge of a resist image has an outline cut sharply in accordance with the exposure irradiated pattern. Also, with regard to the end surface part, a uniform film thickness after development can be maintained as there is no dispersion of heat capacity caused by burning.
(6) A resist image is decreased in a reduction in film thickness and is glossy; pinholes are not produced even if the layer is just etched and gravure-plate-making can be accomplished. Also, a resist image is obtained which has printing durability ensuring that several thousand sheets can be copied if it is subjected to, for example, printing, and the generation of pinholes in the handling before development after the photosensitive film is dried can be avoided or scratching resistance is improved.
(7) A variation in image printing by a laser is reduced and latitude of development is superior.
(8) A reduction in film thickness after development is small and therefore the generation of pinholes is decreased.

### Brief Description of the Drawings:

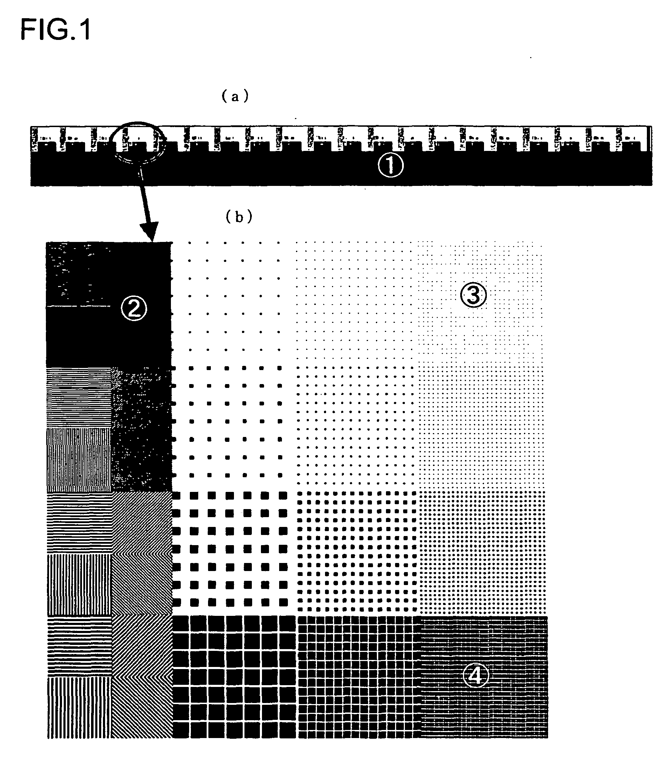

Fig. 1 is a view showing a sensitizing solution test pattern used in Example 1 and measuring positions, where (a) is a test pattern and (b) is an enlarged view of the part marked by a circle in (a).

### Best Mode for Carrying Out the Invention:

Embodiments according to the present invention will be explained hereinafter. However, these embodiments are shown as examples and it is needless to say that various modifications may be possible within the technical spirit of the present invention.

The positive photosensitive composition of the present invention comprises, as essential elements, (A) a high molecular substance having at least one carboxyl group in a molecule and (B) a photo-thermal conversion material that absorbs infrared ray from an image exposure light source and converts it to heat, and, according to the need, preferably further comprises (C) a dissolution inhibitor, (D) a photo-acid generator, (E) at least one resin selected from the group consisting of (1) a vinylpyrrolidone/vinyl acetate copolymer, (2) a vinylpyrrolidone/dimethylaminoethyl methacrylate copolymer, (3) a vinylpyrrolidone/vinyl caprolactam/dimethylaminoethyl methacrylate copolymer, (4) a polyvinyl acetate, (5) a polyvinyl butyral, (6) a polyvinyl formal, (7) a terpene phenolic resin, (8) an alkylphenolic resin, (9) a melamine-formaldehyde resin and (10) a ketone resin and (F) a triarylmethane dye.

As the aforementioned high molecular substance (A), any high molecular substance may be used without any particular limitation insofar as it has at least one carboxyl group in its molecule. Preferable examples of the high molecular substance include a polymer of an unsaturated compound (a1) having at least one carboxyl group and/or carboxyanhydride group and a copolymer of the unsaturated compound (a1) and a compound (a2) copolymerizable with the unsaturated compound. The high molecular substance (A) contains the carboxyl group so as to have an acid value of preferably 30 to 500 and more preferably 200 to 250. The weight average molecular weight of the high molecular substance (A) is preferably 1,500 to 100,000 and more preferably about 7,000 to 10,000.

As the aforementioned unsaturated compound (a1), maleic acid, (meth)acrylic acid, fumaric acid and itaconic acid, and their derivatives are preferable. These compounds may be used either singly or in combinations of two or more.

Preferable examples of the aforementioned maleic acid and its derivative (referred to as a maleic acid monomer) include maleic acid, maleic anhydride, maleic monoester (e.g., monomethyl maleate, monoethyl maleate, mono-*n*-propyl maleate, mono-isopropyl maleate, mono-*n*-butyl maleate, mono-isobutyl maleate and mono-*tert*-butyl maleate) and maleic diester.

Preferable examples of the aforementioned (meth)acrylic acid and its derivative (referred to as a (meth)acryl monomer) include (meth)acrylic acid and (meth)acrylic ester (e.g., methyl (meth)acrylate, ethyl (meth)acrylate, butyl (meth)acrylate and hydroxyethyl (meth)acrylate).

As the compound (a2) copolymerizable with the unsaturated compound (a1), compounds having an unsaturated double bond are preferable and styrene and its derivatives (referred to as styrene monomer) such as styrene, α-methylstyrene, *m*- or p-methoxystyrene, p-methylstyrene, p-hydroxystyrene, 3-hydroxymethyl-4-hydroxy-styrene are particularly preferable. These compounds may be used either singly or in combinations of two or more.

As the aforementioned high molecular substance (A), a polymer of the aforementioned maleic acid monomer, a copolymer of the maleic acid monomer used as major components, a polymer of the aforementioned (meth)acryl monomer, a copolymer of the (meth)acryl monomer used as major components, a copolymer of the maleic acid monomer, the (meth)acryl monomer and other monomer such as the styrene monomer, a styrene/maleic acid copolymer (hereinafter referred to as a copolymer (b1)) obtained by copolymerizing the maleic acid monomer with the styrene monomer, a copolymer of the (meth)acryl monomer and the styrene monomer, derivatives of these polymers or modifications of these polymers are preferable, maleic acid polymer, (meth)acrylic acid polymer, a copolymer having a structure represented by the following formula (6) and/or the formula (7) and a structure represented by the following formula (8) or a copolymer of (meth)acrylic acid, (meth)acrylic acid ester and the styrene monomer are more preferable and a copolymer represented by the following formula (1) are further more preferable.

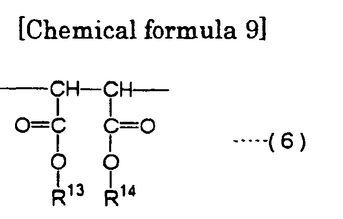

In the formula (6), each of "R¹³ and "R¹⁴ independently represents a hydrogen atom or a monovalent substituted group and is preferably a hydrogen atom, a lower alkyl group or a group having a reactive double bond.

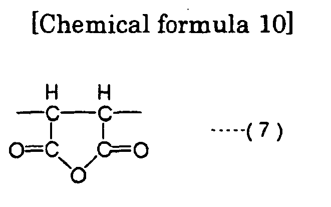

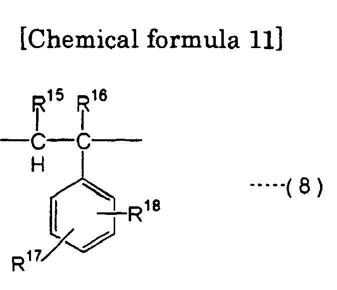

In the formula (8), each of "R¹⁵" and "R¹⁶" independently represents a hydrogen atom or a monovalent substituted group is preferably a hydrogen atom or a methyl group, "R¹⁷" represents a hydrogen atom or a monovalent substituted group and is preferably a hydrogen atom, a hydroxyl group, an alkyl group or an alkoxyl group, and "R¹⁸" represents a hydrogen atom or a monovalent substituted group and is preferably a hydrogen atom a hydroxyalkyl group.

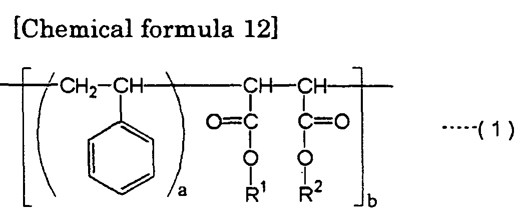

In the formula (1), each of "R¹" and "R²" independently represents a hydrogen atom or a monovalent substituted group, and is preferably a hydrogen atom or a substituted or unsubstituted alkyl group and more preferably a hydrogen atom, a lower alkyl group or an alkoxyalkyl group. When "R¹" and "R²" are respectively present in plural, plural "R¹"s and plural "R²"s may be the same or different. At least one of "R¹" and "R²" is preferably a hydrogen atom. "a" denotes an integer from 0 or 1 or more and is preferably 1 to 3. "b" denotes an integer of 1 or more and is preferably 6 to 8.

No particular limitation is imposed on the method for producing the above styrene/maleic acid copolymer and the copolymer may be produced according to a known method. It is preferable to react a styrene/maleic anhydride copolymer (namely, a copolymer of the styrene monomer and maleic anhydride) with a compound having a hydroxyl group to esterify, thereby obtaining the above styrene/maleic acid copolymer.

Examples of the compound having a hydroxyl group include, though not particularly limited to, alcohols such as isopropanol, *n*-propanol, isopropanol/cyclohexanol, butyl alcohol, isooctanol and ethylene glycol, ethylene glycol ethers such as ethylene glycol butyl ether, and diethylene glycol ethers such as diethylene glycol ethyl ether.

Also, as the aforementioned high molecular substance (A), compounds (hereinafter referred to as a copolymer (b2)) obtained by modifying the aforementioned copolymer (b1) by using a compound having a reactive double bond may be used. In this case, the ratio of the structure represented by the formulae (6) and (7) to the structure represented by the formula (8) is preferably about 1. Specifically, it is possible to produce the above copolymer (b2) by reacting an acid hydride group or carboxyl group in the copolymer (b1) with the compound having a reactive double bond. In this case, it is necessary that a carboxyl group necessary to carry out alkali development be left in the copolymer.

As the compound having a reactive double bond, a compound having a carbon-carbon double bond is preferable. Preferable examples of the compound having a reactive double bond include an unsaturated alcohol (e.g., allyl alcohol, 2-butene-1-2-ol, furfuryl alcohol, oleyl alcohol, cinnamyl alcohol, 2-hydroxyethyl acrylate, hydroxyethyl methacrylate and N-methylol acrylamide), alkyl (meth)acrylate (e.g., methyl methacrylate and *t*-butyl methacrylate), an epoxy compound having one oxirane ring and one reactive double bond (e.g., glycidyl acrylate, glycidyl methacrylate, allyl glycidyl ether, α-ethylglycidyl acrylate, crotonyl glycidyl ether and itaconic acid monoalkyl monoglycidyl ester).

As the above copolymer (b2), a compound may be used which is obtained by reacting a compound into which a reactive double bond is introduced by an unsaturated alcohol, with the above epoxy compound having one oxirane ring and one reactive double bond, to thereby increase the concentration of a reactive double bond.

No particular limitation is imposed on a method for producing the above copolymer (b1) or (b2) and the method may be carried out according to a known method (see, for example, Patent documents 32 to 34). A reactive double bond may be introduced also into the high molecular substance having a carboxyl group, other than a styrene/maleic acid polymer in the same manner as above. The imparting of a reactive double bond to the high molecular substance is preferable from the viewpoint of raising hardness and improving printing durability.

There is no particular limitation to the content of the high molecular substance (A) in the positive photosensitive composition of the present invention. However, the content is preferably 80 to 98% by weight and more preferably 90 to 95% by weight based on the total solid amount of the components (A), (B), (C), (D), (E) and (F). The high molecular substance (A) may be used either singly or in combinations of two or more.

As the above photo-thermal conversion material (B), any material may be used insofar as it is a compound capable of converting absorbed light into heat. Examples of the photo-thermal conversion material (B) include organic or inorganic pigments and dyes, organic coloring matter, metals, metal oxides, metal carbonates and metal borates, which have an absorption band in a part or all of the infrared region of wavelength of 700 to 1,100 nm.
A preferable example of the photo-thermal conversion material (B) is a light-absorbing dye that efficiently absorbs light having the above wavelength range and does not almost absorb light in the ultraviolet region or does not substantially sensitized by the light if it absorbs the light. A Compound represented by the following formula (3) or (4) and their derivatives are preferably used.

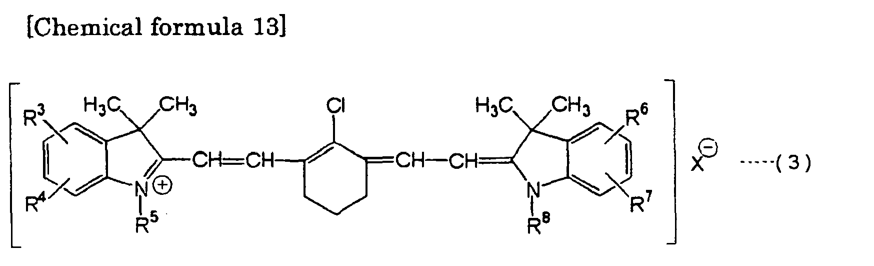

In the formula (3), each of "R³" to "R⁸" independently represents a hydrogen atom, a lower alkyl group (preferably an alkyl group having 1 to 3 carbon atoms) or a lower alkoxyl group (preferably an alkoxyl group having 1 to 3 carbon atoms). "X⁻" represents a counter anion and examples of "X" include halogen atom, ClO₄, BF₄, *p*-CH₃C₆H₄SO₃ or PF₆.

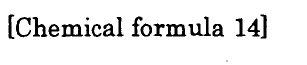

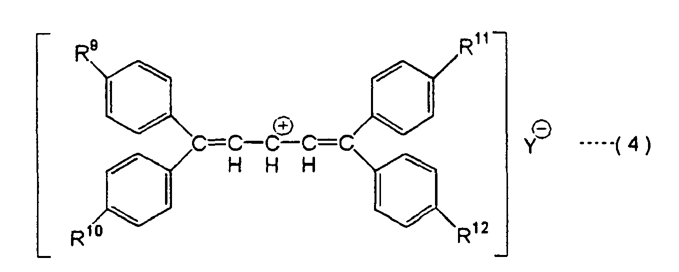

In the formula (4), each of "R⁹" to "R¹²" independently represents a hydrogen atom, a methoxyl group, -N(CH₃)₂ or -N(C₂H₅)₂ and "Y" represents a counter anion. Examples of "Y" include C₄H₉-B(C₆H₅)₃, *p*-CH₃C₆H₄SO₃ or CF₃SO₃.

As the compound represented by the formula (4), near-infrared ray absorbing dyes are preferable which have the maximum absorption wavelength in the near-infrared region and are represented by the following formulae (9) to (12).

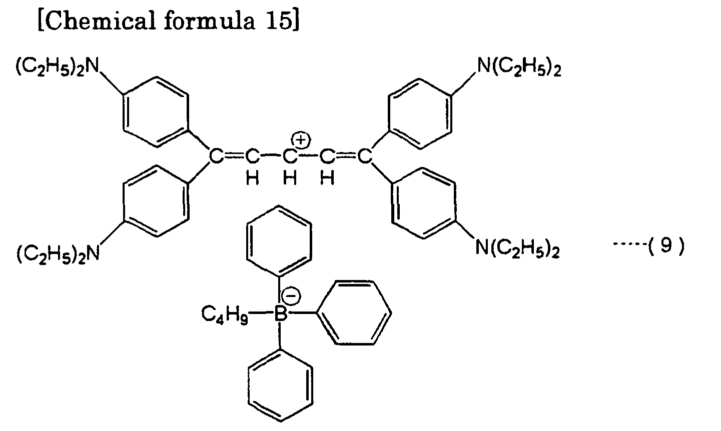

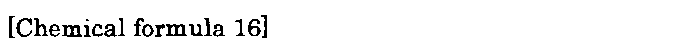

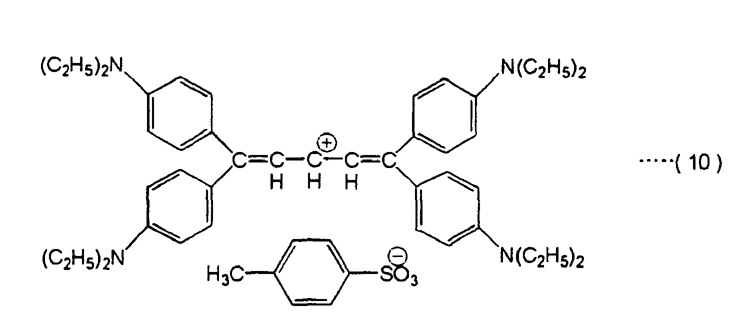

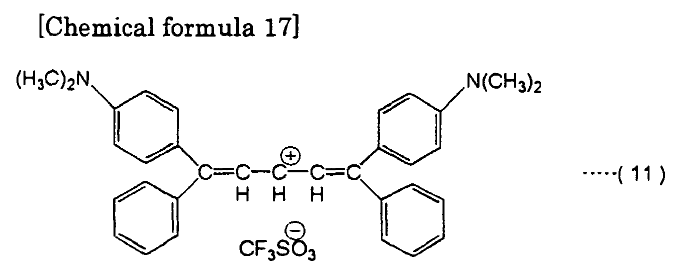

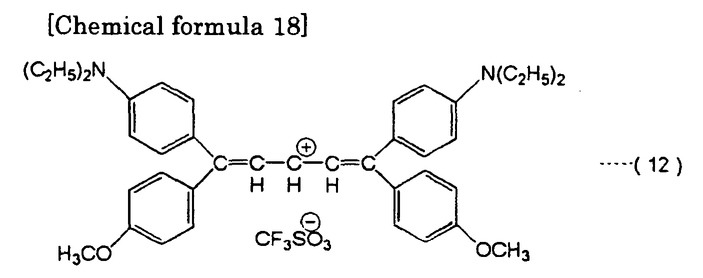

Also, examples of other light-absorbing dyes include cyanine dyes so-called in a wide sense which have the structure in which a heterocyclic ring containing a nitrogen atom, an oxygen atom or a sulfur atom are combined by a polymethine (-CH=)ₙ as described in Patent document 6. Specific examples of these cyanine dyes include a quinoline type (so-called cyanine type), indole type (so-called indocyanine type), benzothiazole type (so-called thiocyanine type), iminocyclohexadiene type (so-called polymethine type), pyrylium type, thiapyrylium type, squarylium type, croconium type and azulenium type. Among these types, a quinoline type, indole type, benzothiazole type, iminocyclohexadiene type, pyrylium type or thiapyrylium type is preferable. Particularly, phthalocyanine or cyanine is preferable.

The aforementioned photo-thermal conversion material (B) has an absorption band in a part or all of the infrared region of a wavelength of 700 to 1,100 nm, has the characteristics that it absorbs laser light of the infrared wavelength region to be heat-decomposed, and participates in molecular reduction/abrasion relative to alkali solubility which is caused by thermal cutting of a molecule of the high molecular substance (A) having a carboxyl group.

The quantity of the photo-thermal conversion material to be added relates to whether heat generated in exposure is excessive or insufficient and also, the intensity of the infrared laser relates to whether the heat decomposition of organic high molecular substance existing in the exposed portion is excessive or insufficient. Therefore, the amount of the photo-thermal conversion material is designed to be an appropriate amount. The content of the photo-thermal conversion material (B) in the positive photosensitive composition of the present invention is preferably 0.1 to 10% by weight and more preferably 1 to 4% by weight based on the total solid amount of the components (A), (B), (C), (D), (E) and (F).

The aforementioned dissolution inhibitor (C) is compounded for the purpose of increasing a time difference of solubility in an alkali developing solution between an exposed portion and an unexposed portion. As the dissolution inhibitor (C), a compound is used which has the ability of forming a hydrogen bond together with the high molecular substance (A) to reduce the solubility of the high molecular substance, does not almost absorb light in the infrared region and is not decomposed by light in the infrared region.

As the dissolution inhibitor (C), it is preferable to use the compound (4,4'-[1-[4-[1-(4-hydroxyphenyl)-1-methyl ethyl] phenyl] ethylidene] bisphenol) represented by the following formula (2).

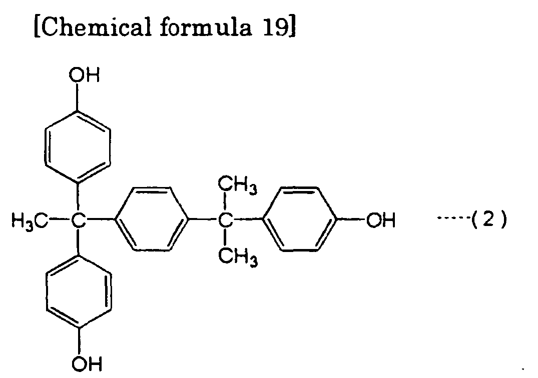

Also, known dissolution inhibitors may be used as the dissolution inhibitor (C). Specific examples of the dissolution inhibitor (C) include a sulfonic ester, phosphoric ester, aromatic carboxylic ester, aromatic disulfone, carboxyanhydride, aromatic ketone, aromatic aldehyde, aromatic amine, aromatic ether, acid color developing dyes having a lactone skeleton, thiolactone skeleton, N,N-diaryl amide skeleton or diaryl methylimino skeleton, base color developing dyes having lactone skeleton, thiolactone skeleton or sulfolactone skeleton, nonionic surfactant and so on. Among these materials, acid color developing dye having lactone skeleton is preferable.

The content of the dissolution inhibitor (C) in the positive photosensitive composition of the present invention is preferably 0.5 to 8% by weight and more preferably 1 to 5% by weight based on the total solid amount of the components (A), (B), (C), (D), (E) and (F). These dissolution inhibitors may be used either singly or in combinations of two or more.

The foregoing photo-acid generator (D) is a material that generates an acid by the aid of light and acts as a photo sensitizer. Examples of the photo-acid generator (D) include a diphenyliodonium salt, triphenylsulfonium salt, aromatic sulfonic ester, triazine compound and diazodisulfone type compound. Compounds represented by the following formulae (13) to (47) are preferable and compounds represented by the following formula (5) are particularly preferable.

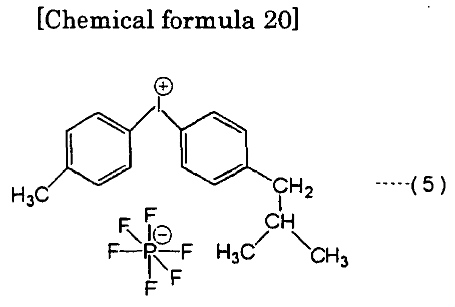

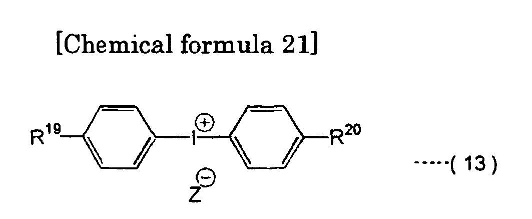

In the formula (13), each of "R¹⁹" and "R²⁰" independently represents a hydrogen atom, an alkyl group or an alkoxyl group, and is preferably a hydrogen atom, a methyl group, a *tert*-butyl group, a methylpropyl group or methoxyl group. "Z⁻" represents a counter anion and examples of "Z" include inorganic acid anions such as PF₆, CF₃SO₃, C₄F₉SO₃, SbF₆ and BF₄, and organic acid anions such as p-toluene- sulfonic acid and camphor-β-sulfonic acid.

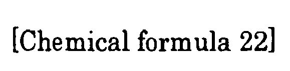

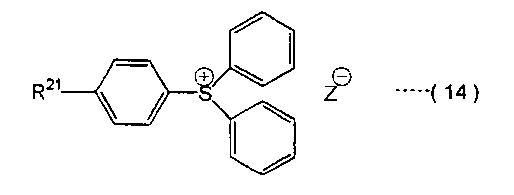

In the formula (14), "R²¹" represents a hydrogen atom, an alkyl group, an alkoxyl group or an -SC₆H₅ group, and is preferably a hydrogen atom, a methyl group, a *tert*-butyl group, a methylpropyl group or a methoxyl group. "Z" is the same as that shown in the formula (13).

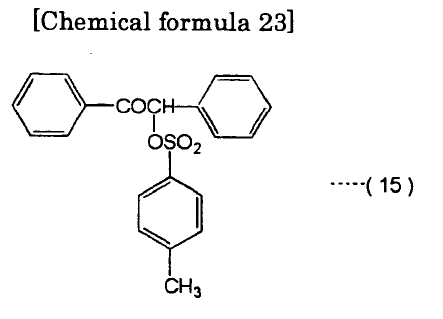

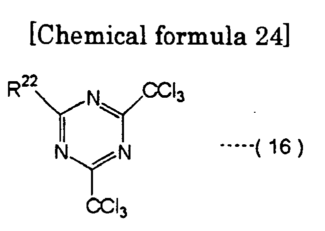

In the formula (16), "R²²" represents a monovalent organic group and examples of "R²²" include a trichloromethyl group, a phenyl group, a p-methoxyphenyl group, a dimethoxyphenyl group, a *p*-CH₃SC₆H₄ group, a p-chlorophenyl group, a methoxystyryl group, a dimethoxystyryl group, a trimethoxystyryl group, a propoxystyryl group, a butoxystyryl group, a pentyloxystyryl group, a p-methoxy-m-chlorostyryl group, a 4'-methoxy-1'-naphthyl group and so on.

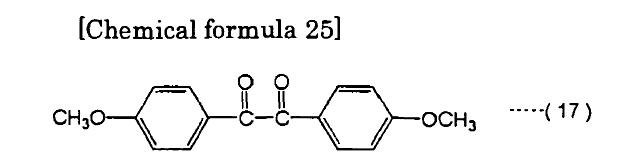

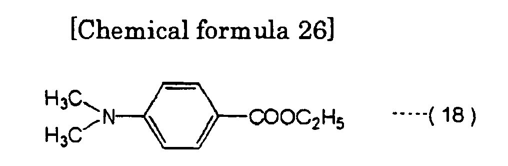

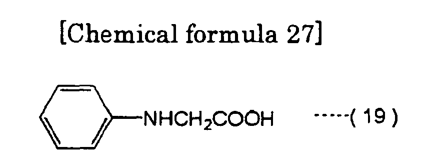

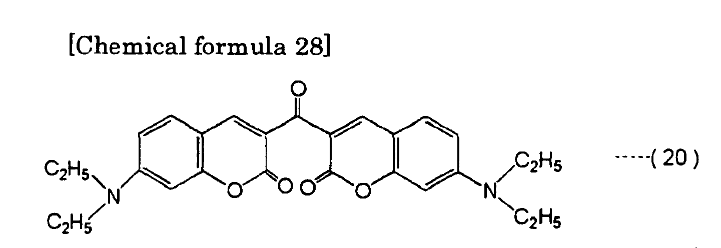

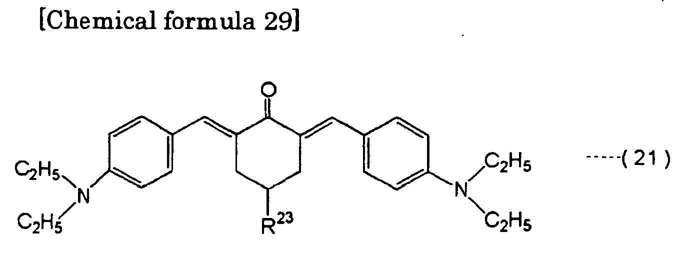

In the formula (21), "R²³" represents a hydrogen atom or a mono valent organic group, and examples of "R²³" include a hydrogen atom, a *tert-*butyl group and so on.

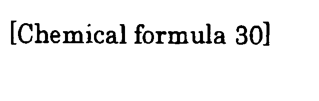

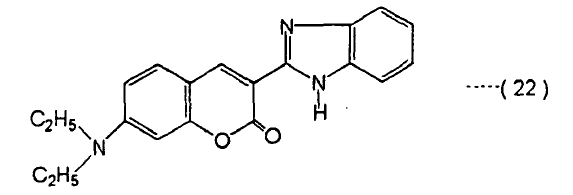

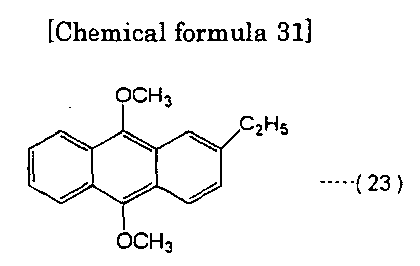

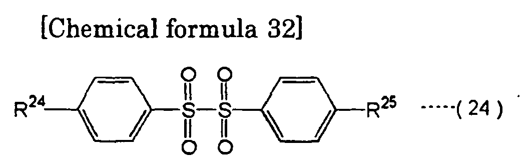

In the formula (24), each of "R²⁴" and "R²⁵" independently represents a hydrogen atom or a monovalent organic group, and examples of "R²⁴" or "R²⁵" include a hydrogen atom, a methyl group and a *tert*-butyl group.

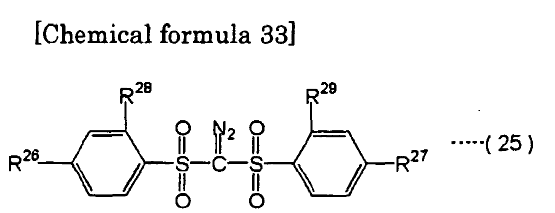

In the formula (25), each of "R²⁶" and "R²⁷" independently represents a hydrogen atom or a monovalent substituted group, and examples of "R²⁶" or "R²⁷" include a hydrogen atom, a chlorine atom, a methyl group and a *tert-*butyl group. Each of "R²⁸" and "R²⁹" independently represents a hydrogen atom or a methyl group.

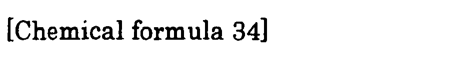

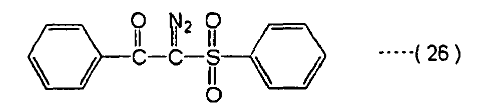

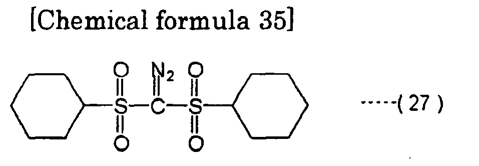

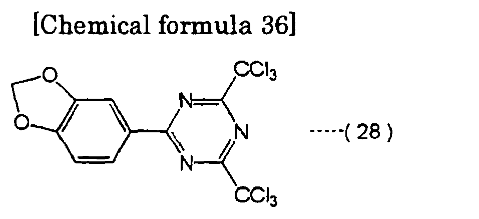

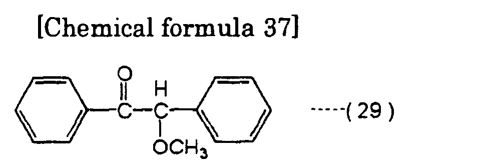

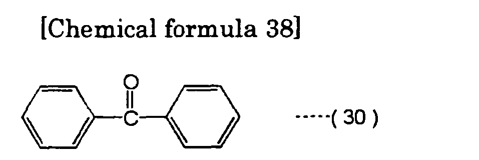

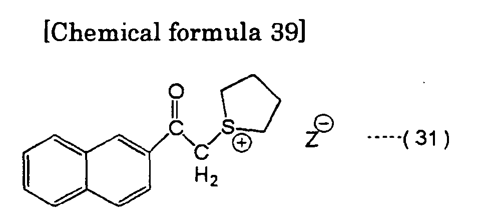

In the formula (31), "Z" is the same as that shown in the formula (13).

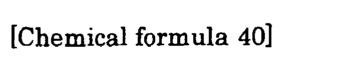

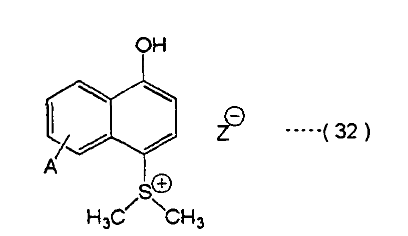

In the formula (32), "Z" is the same as that shown in the formula (13). "A" represents a hydrogen atom or a hydroxyl group.

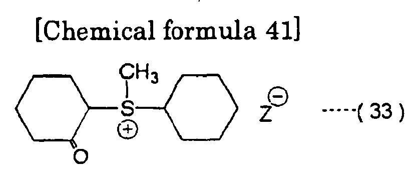

In the formula (33), "Z⁻" is the same as that shown in the formula (13).

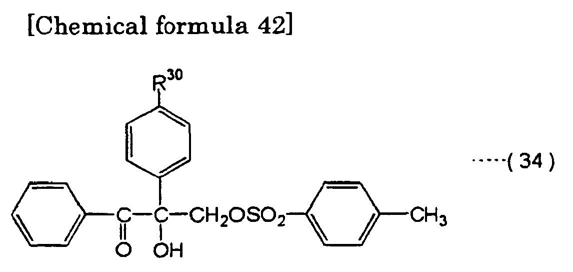

In the formula (34), "R³⁰" represents a hydrogen atom or an -SCH₃ group.

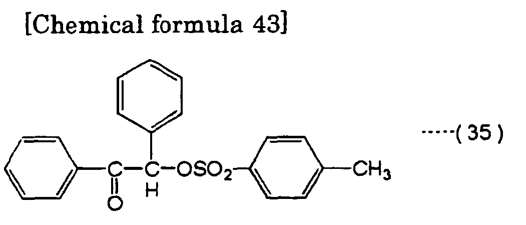

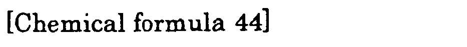

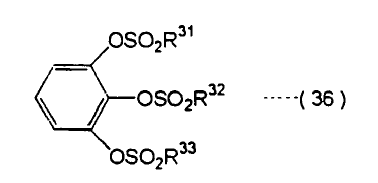

In the formula (36), each of "R³¹ to "R³³ independently represents a monovalent organic group, and is preferably an alkyl group such as a methyl group or ethyl group.

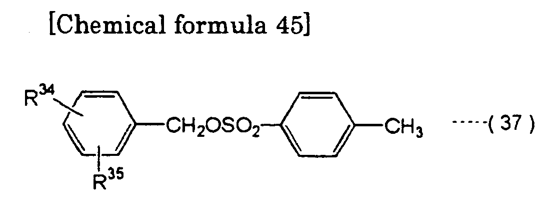

In the formula (37), each of "R³⁴" and "R³⁵" independently represents a hydrogen atom or an NO₂ group.

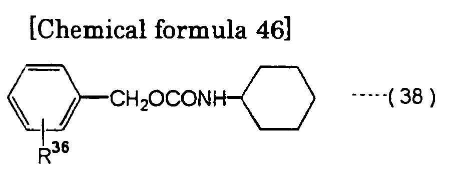

In the formula (38), "R³⁶" represents a hydrogen atom or an NO₂ group.

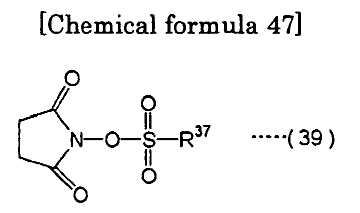

In the formula (39), "R³⁷" represents a methyl group, a CF₃ group, a phenyl group or a p-methylphenyl group.

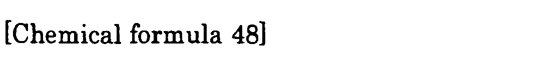

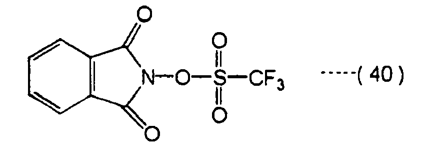

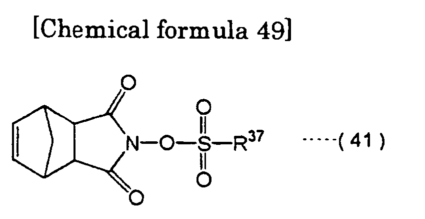

In the formula (41), "R³⁷" is the same as that shown in the formula (39).

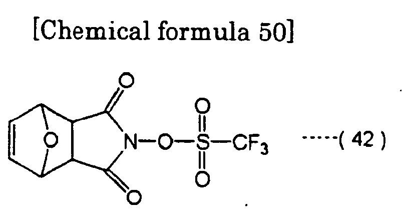

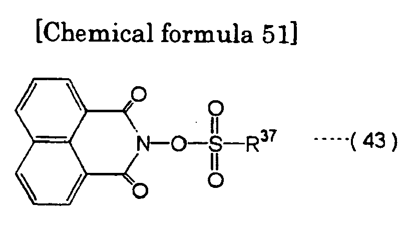

In the formula (43), "R³⁷" is the same as that shown in the formula (39).

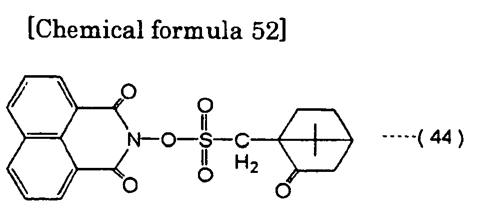

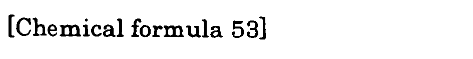

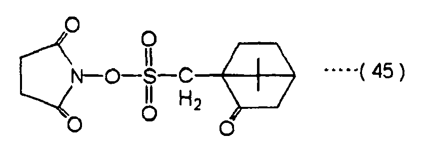

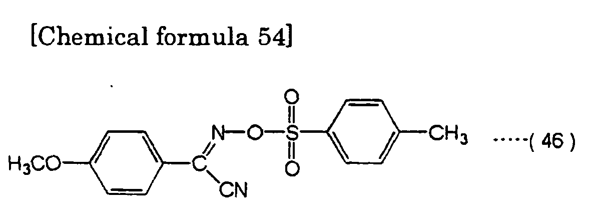

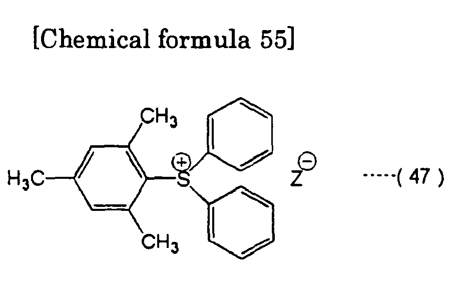

In the formula (47), "Z^{.}" is the same as that shown in the formula (13).

As the photo-acid generator, specifically, the photo-acid generator such as IRGACURE series manufactured by Ciba Specialty Chemicals Inc., and products (trade name: BDE, Anisil, BBI-102, TAZ-101, TAZ-104, TAZ-106, TAZ-110 and BC) of Midori Kagaku Co., Ltd. can be widely used. Also, diazodisulfone type or triphenylsulfonium type photo-acid generators manufactured by Wako Pure Chemical Industries, Ltd. may be used.

The content of the photo-acid generator (D) in the positive photosensitive composition of the present invention is preferably 0.5 to 10% by weight and more preferably 1 to 5% by weight based on the total solid amount of the components (A), (B), (C), (D), (E) and (F). These photo-acid generators may be used either singly or in combinations of two or more and may also be used in combination with other photo sensitizer.

The aforementioned resin (E) is at least one alkali-soluble resin selected from the group consisting of (1) a vinylpyrrolidone/vinyl acetate copolymer, (2) a vinylpyrrolidone/dimethylaminoethyl methacrylate copolymer, (3) a vinylpyrrolidone/vinyl caprolactam/dimethylaminoethyl methacrylate copolymer, (4) a polyvinyl acetate, (5) a polyvinyl butyral, (6) a polyvinyl formal, (7) a terpene phenolic resin, (8) an alkylphenolic resin, (9) a melamine-formaldehyde resin and (10) a ketone resin, and functions as an adhesion improver.

The aforementioned vinylpyrrolidone/vinyl acetate copolymer (1) (hereinafter referred to as a PVP/VA copolymer) is a thermoplastic resin obtained by copolymerizing vinylpyrrolidone with vinyl acetate and has the structure represented by the formula (48).

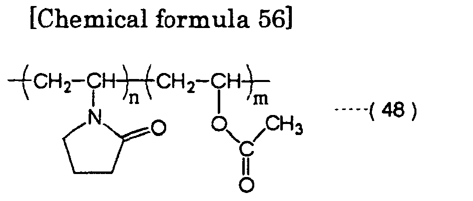

In the formula (48), "n" and "m" denote an integer of 1 or more, respectively. Although there is no particular limitation to the ratio of vinylpyrrolidone to vinyl acetate in the PVP/VA copolymer, the PVP/VA copolymers in which the ratio of vinylpyrrolidone to vinyl acetate is 70/30 to 30/70 are preferable and the PVP/VA copolymers in which the ratio of vinylpyrrolidone to vinyl acetate is 50/50 are more preferable.

Although there is no particular limitation to a method for producing the PVP/VA copolymer, a linear random copolymer obtained by free-radical polymerization of vinylpyrrolidone with vinyl acetate is preferable. The molecular weight of the PVP/VA copolymer is preferably 10,00 to 60,000 and more preferably 20,000 to 50,000 although no particular limitation is imposed on it.

The aforementioned vinylpyrrolidone/dimethylaminoethyl methacrylate copolymer (2) has the structure represented by the following formula (49).

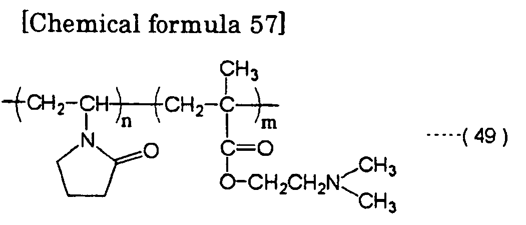

In the formula (49), "n" and "m" denote an integer of 1 or more, respectively.

The aforementioned vinylpyrrolidone/vinyl caprolactam/dimethylaminoethyl methacrylate copolymer (3) is a copolymer of vinylpyrrolidone, vinyl caprolactam and dimethylaminoethyl methacrylate and has the structure represented by the following formula (50).

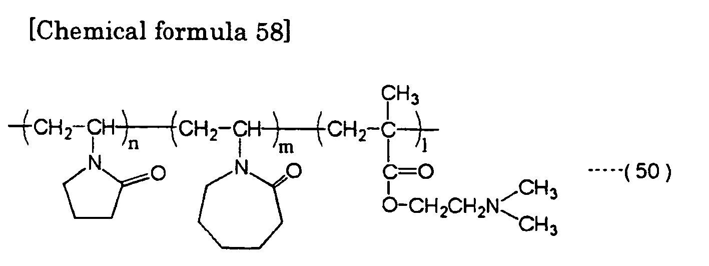

In the formula (50), "n", "m" and "1" denote an integer of 1 or more, respectively.

The aforementioned polyvinyl acetate (4) is a homopolymer of vinyl acetate or a copolymer of vinyl acetate used as a major component and has the structure represented by the following formula (51).

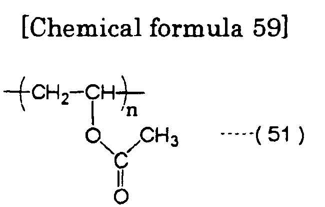

In the formula (51), "n" denotes an integer of 1 or more. As the polyvinyl acetate, for example, SAKNOHOL SN-09T (trade name) manufactured by Denki Kagaku Kogyo Kabushiki Kaisha is preferably used.

The aforementioned polyvinyl butyral (abbreviation: PVB) (5) is a resin obtained by reacting a polyvinyl alcohol with butyl aldehyde to form a butyral compound and has the structure represented by the following formula (52).

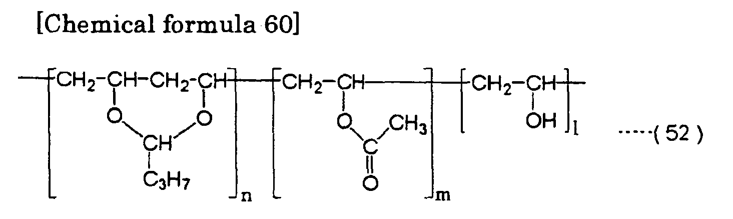

In the formula (52), "n", "m" and "1" denote an integer of 1 or more, respectively. Specific and preferable examples of the polyvinyl butyral include products of Denki Kagaku Kogyo Kabushiki Kaisha, for example, Denka Butyral 5000A and 6000 EP, and products of Sekisui Chemical Co., Ltd. for example, low degree-polymerization type BL-1, BL-2, BL-S and BX-L, middle degree-polymerization type BM-1, BM-2, BM-5 and BM-S and high-degree polymerization type BH-3, BH-S, BX-1, BX-2, BX-5 and BX-55. It is particularly preferable to use BL-S, BM-S and BH-S having solubility in various types of solvent.

The aforementioned polyvinyl formal (PVFM) (6) is a resin that has high electric insulation and is represented by the following formula (53).

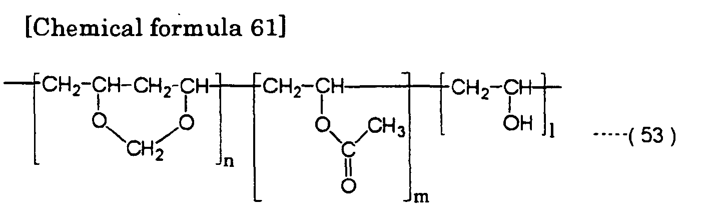

In the formula (53), "n", "m" and "1" denote an integer of 1 or more, respectively. Although no particular limitation is imposed on a method for producing the polyvinyl formal, for example, a polyvinyl acetate is dissolved in acetic acid, formaldehyde and sulfuric acid are added to the solution to run a saponification reaction and a formal reaction simultaneously, and dilute sulfuric acid is added to the reaction solution to precipitate a polyvinyl formal, followed by a solvent recovery step, washing step and drying step, to obtain a product.

As the aforementioned terpene phenolic resin (7), a wide range of conventionally known resins may be used. Specific and preferable examples of the resin include TAMANOL 803L and 901 (trade name, manufactured by Arakawa Chemical Industries, Ltd.)

As the aforementioned alkylphenolic resin (8), a wide range of conventionally known resins may be used. Specific and preferable examples of the resin include TAMANOL 520S, 521, 526, 586 and 572S (trade name, manufactured by Arakawa Chemical Industries, Ltd.).

The aforementioned melamine-formaldehyde resin (9) is resin obtained by an addition-condensation reaction of melamine and formaldehyde. A wide range of known melamine-formaldehyde resins may be used as this melamine-formaldehyde resin. Specifically, it is preferable to use, for example, BANCEMINE SM-960 (trade name) manufactured by Harima Chemicals, Inc.

As the ketone resin (10), known ketone resins may be used without any particular limitation. For example, the ketone resin may be obtained by reacting ketones with formaldehyde according to the known method. Examples of the ketones include methyl ethyl ketone, methyl isobutyl ketone, acetophenone, cyclohexanone, and methyl cyclohexanone. Particularly, cyclohexanone and acetophenone are preferable. As the ketone resin, cyclohexanone type ketone resins represented by the following formula (54) and acetophenone type ketone resins having the structure represented by the following formula (55) are preferable.

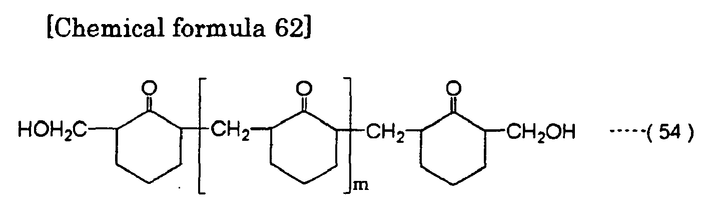

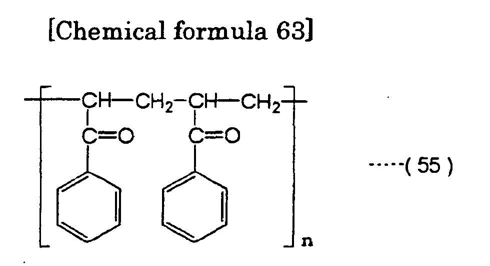

In the formulae (54) and (55), "m" and "n" denote an integer of 1 or more, respectively.

The content of the resin (E) in the positive photosensitive composition of the present invention is preferably 1 to 40% by weight and more preferably 5 to 30% by weight based on the total solid amount of the components (A), (B), (C), (D), (E) and (F).

As the aforementioned triarylmethane dye (F), a wide range of conventionally known triarylmethane type color dyes may be used. Specifically, Methyl Violet, Crystal Violet, Victoria Blue B, Oil Blue 613 (trade name, manufactured by Orient Chemical Industries, Ltd.) and their derivatives are preferable as the dye (F). These triarylmethane dyes may be used either singly or in combinations of two or more.

The use of color dyes has the effect that when a pattern is made by development, pinholes and dusts on the surface of the photosensitive film can be clearly recognized and it is therefore easy to carry out application work using a retouching liquid (Opaque). The higher the concentration of the dye is, the more easily these pinholes and dusts can be seen, which is preferable. Incidentally, because this retouching operation is not allowed in semiconductor industries, an operation is carried out in a clean room, whereas in printing industries and industries relevant to electronic parts, the retouching operation is carried out to remake inferior products.

The content of the triarylmethane dye (F) in the positive photosensitive composition of the present invention is preferably 0.1 to 10% by weight and more preferably 1 to 4% by weight based on the total solid amount of the components (A), (B), (C), (D), (E) and (F).

The positive photosensitive composition of the present invention may comprise, besides the aforementioned components, if necessary, various additives such as coloring agents such as other pigments or dyes, a photo sensitizer, a developing promoter, an adhesion-modifying agent and a coating improving agent. As the developing promoter, for example, dicarboxylic acid, amines or glycols is preferably added in a small amount.

The positive photosensitive composition of the present invention is usually used in the form of a solution obtained by dissolving the composition in a solvent. The proportion by weight of the solvent to be used is generally in a range from 1 to 20 times the total solid content of the photosensitive composition.

As the solvent, any solvent may be used without any particular limitation insofar as it has enough solubility to components used and imparts good coatability, and a cellosolve type solvent, propylene glycol type solvent, ester type solvent, alcohol type solvent, ketone type solvent or highly polar solvent may be used. Examples of the cellosolve type solvent include methyl cellosolve, ethyl cellosolve, methyl cellosolve acetate and ethyl cellosolve acetate. Examples of the propylene glycol type solvent include propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether. Examples of the ester type solvent include butyl acetate, amyl acetate, ethyl butyrate, butyl butyrate, diethyl oxalate, ethyl pyruvate, ethyl-2-hydroxybutyrate, ethyl acetoacetate, methyl lactate, ethyl lactate and methyl-3-methoxypropionate. Examples of the alcohol type solvent include heptanol, hexanol, diacetone alcohol and furfuryl alcohol. Examples of the highly polar solvent include ketone type solvents such as cyclohexanone and methyl amyl ketone, dimethylformamide, dimethylacetamide and N-methyl-pyrrolidone. Examples other than the above include acetic acid, mixtures of these solvents, and, further, solvents obtained by adding an aromatic hydrocarbon to these solvents.

The positive photosensitive composition of the present invention may be produced in the following manner. Usually, the above each component is dissolved in a solvent such as a cellosolve type solvent or propylene glycol type solvent to make a solution, which is then applied to the surface of the support, specifically, the copper or copper sulfate plating surface of the plate-making roll for gravure printing use and naturally dried. Then, the roll is rotated at high speed so that the surface of the plate-making roll go through the air. A mass effect due to centrifugal force in the photosensitive film and the condition of the neighborhood of the surface placed under a slightly negative pressure allow the concentration of residual solvents to be reduced to 6% or less, to thereby make a positive photosensitive film with the photosensitive composition layer being formed on the surface of the support.

As a coating method, meniscus coating, fountain coating, dip coating, rotary coating, roll coating, wire bar coating, air-knife coating, blade coating and curtain coating may be used. The thickness of the coating film is in a range preferably from 1 to 6 µm and more preferably 3 to 5 µm.

As the light source used for image exposure of the positive photosensitive composition layer, a semiconductor laser and a YAG laser which emit infrared laser rays having a wavelength of 700 to 1,100 nm are preferable. Besides the above, a solid laser such as a ruby laser and LED may be used. The intensity of the laser light source is designed to be 2.0 x 10⁶ mJ/scm² or more and particularly preferably 1.0 x 10⁷ mJ/scm² or more.

As a developing solution used for the photosensitive film formed by using the positive photosensitive composition of the present invention, a developing solution comprising an inorganic alkali (e.g., salts of Na or K) or an organic alkali (e.g., TMAH (Tetra Methyl Ammonium Hydroxide) or choline) is preferable.

The development is carried out at usually about 15 to 45°C and preferably 22 to 32°C by dipping development, spray development, brush development, ultrasonic development and so on.

### EXAMPLES

The present invention will be explained in more detail by way of examples, which are, however, shown as examples but should not be interpreted as limiting of the present invention.

### (Example 1)

The ingredients and proportions shown in Table 1 were used to prepare positive photosensitive compositions as test sensitizing solutions.

**[Table 1]**

| | Ingredients | Proportion (parts by weight) |
|---|---|---|
| Component (A) | Resin A1 | 100 |
| Component (B) | IR-photosensitive dye B1 | 3 |
| Component (C) | Dissolution inhibitor 1 | 2 |
| Component (D) | Photo-acid generator 1 | 2 |
| Component (E) | Resin E1 | 8 |
| Component (F) | Color dye F1 | 2 |
| Solvent | PM | 590 |
| | IPA | 737 |
| | MEK | 589 |

Each component in Table 1 is as follows.
Resin A1: SMA 1440 (manufactured by SARTOMER Company, Inc., a partial ester of styrene/maleic anhydride copolymer with butyl cellosolve)
IR-photosensitive dye B1: Infrared absorbing dye represented by the above formula (3).
Dissolution inhibitor 1: TrisP-PA (manufactured by Honshu Chemical Industry Co., Ltd., compound represented by the above formula (2)).
Photo-acid generator 1: IRGACURE 250 (manufactured by Ciba Specialty Chemicals Inc., compound represented by the above formula (5)).
Resin E1: PVP/VA copolymer (copolymer of vinylpyrrolidone and vinyl acetate, vinylpyrrolidone/vinyl acetate: 50/50, molecular weight: 46,000, glass transition temperature: 96°C).
Color dye F1: Oil Blue 613 (manufactured by Orient Chemical Industries, Ltd., Color Index (C.I.) No. 42595).
PM: Propylene glycol monomethyl ether.
IPA: Isopropyl alcohol.
MEK: Methyl ethyl ketone.

The following experiments were made using the obtained test sensitizing solutions. The experiment was carried out under the condition that laboratory was maintained at a temperature of 25°C and the humidity shown in Table 2. A plate-making roll of φ 200 mm which used iron as base material of the roll and was plated with copper sulfate and mirror-polished was rotated at 25 r.p.m. with the both ends thereof being chucked by a fountain coating apparatus (apparatus equipped with a dehumidifier and a humidifier where the humidity can be controlled desirably) and thoroughly wiped and cleaned by a wiping cloth. It is to be noted that the fountain coating apparatus has the ability to avoid the phenomenon that solvents in the positive photosensitive composition are vaporized to change the ratio of these solvents during coating.

Thereafter, a pipe allowing the test sensitizing solution to be overflowed from the top thereof was positioned at one end of the plate-making roll so as to form a gap of about 500 µm from the roll. The pipe was moved from one end to the other end of the roll with making the test sensitizing solution overflow in an amount necessary for coating, to apply the test sensitizing solution uniformly to the roll by a spiral scan method, and the rotation was continued at 25 r.p.m. for 5 minutes after the application was finished and then stopped.

Five minutes were taken for waiting until oozing of a liquid was observed, with the result that the generation of the oozing of a liquid could not be observed with the naked eye. Then, the film thickness was measured, to find that there was no difference in thickness between the lower surface part and upper surface part of the roll. It was thus confirmed that the photosensitive film dried to a solid condition permitting no oozing of a liquid was set.

In succession, the test roll was rotated at 100 r.p.m. for 20 minutes and then stopped to measure the concentration of residual solvents in the photosensitive film, to find that the concentration was 2.9%.

Then, the test roll was fit to an exposure apparatus (manufactured by Think Laboratory) mounted with a high-power semiconductor laser head of CreoScitex Co., Ltd. and then irradiated with laser light having a wavelength falling in the infrared region to print a positive image. Next, the test roll was fit to a developing machine and was developed with rotating the roll and lifting the developing tank until no residue was observed, followed by washing with water. As the developing solution, 4.2% KOH (25°C) was used. The resulting resist image was evaluated by a microscope. The results are shown in Table 2.

**[Table 2]**

| | Humidity (%) | Adhesion | Sensitivity (mJ/cm²) | Development (seconds) | Rate of residual film (%) | Image | Resolution of edges | Latitude of development |
|---|---|---|---|---|---|---|---|---|
| Example 1-1 | 35 | ⊚ | 180 | 75 | 71 | ⊚ | ⊚ | ⊚ |
| Example 1-2 | 45 | ⊚ | 180 | 75 | 73 | ⊚ | ⊚ | ⊚ |
| Example 1-3 | 55 | ⊚ | 180 | 75 | 72 | ⊚ | ⊚ | ⊚ |

The methods of evaluation in Table 2 are as follows.

### 1) Resolution of edges

Using the resolution test pattern shown in Fig. 1, whether or not the edges of 7.9 µm line of a check and grating was sharp. In the table, "⊚" shows a good result and shows that the sample passed the resolution test and "x" shows that no image was formed and plate-making could not be attained and the sample did not pass the resolution test.

### 2) Latitude of development

The latitude of development was measured using a cellar (device capable of automatically measuring the opening ratio of dots) manufactured by Dai Nippon Printing Co., Ltd. A test was made in which the number of developing processes was increased (three times in the Example). In the case where the cell area falls in 60 to 75 µm² by exposure to light of 7.9 µm x 7.9 µm, this cell area falls in the allowable range of printing density and shows that the latitude of development is good, which is expressed as "⊚" in the table. In the case where the cell area is out of the allowable range of printing, the latitude of development is expressed as "x" in the table.

### 3) Adhesion

The tesa test: in a cross-cut adhesion test using a DIN EN ISO 2409 tesa tape, the case where 100 squares all remain is defined as "⊚", the case where squares less than 20% are peeled is defined as "O" and the case where 20% or more of squares are peeled is defined as "x".

### 4) Sensitivity

Exposure amount was varied to find one at which an image pattern was reproduced most exactly to decide the sensitivity. As the exposure apparatus, a thermal imaging head manufactured by Creo Co., Ltd. was used.

### 5) Development

The development time taken until no residue was found was measured.

### 6) The rate of residual film

Film thicknesses before and after development were measured using FILMETRICS Thin Film Analyzer F20 (manufactured by Filmetrics Co.) which calculate thickness of coating film to calculate the rate of residual film.

### 7) Image

The reproducibility of an original image was evaluated. ⊚: Very good, x: Very inferior, -: An image disappeared by development.

The test pattern of the sensitizing solution and measuring positions are shown in Fig. 1. Check items and measuring method for the measuring positions in Fig. 1 are shown in Table 3.

**[Table 3]**

| Measuring positions | Check items | Photography | Measurement of area (cellular) |
|---|---|---|---|
| ① | Presence or absence of developing residue | - | - |
| ② | 1 Pixel check | O | - |
| ③ | 1 Pixel highlight | O | O |
| ④ | 7 µm grating | O | O |

As shown in Table 2, the positive photosensitive composition of Example 1 made it possible to carry out good development to obtain a sharp pattern freed of residues in about 70 seconds in the condition of a room temperature of 25°C and a humidity of 35 to 55%. Also, a good latitude of development was obtained.

The experiment was also made in the case of using a copper surface or an aluminum surface in place of the copper sulfate plating surface. In all of these cases, the same satisfactory results as in Example 1 were obtained. In the case of the aluminum surface, a especially wide latitude of development was obtained.

### (Examples 2 to 6)

The same experiments as in Example 1-2 were made except that the components (B) and (F) in the compositions were altered as shown in Table 4. The measurement was made under a humidity of 45%. The results are shown in Table 4.

**[Table 4]**

| | Component (B) proportion | Component (F) proportion | Adhesion | Sensitivity (mJ/cm²) | Development (seconds) | Rate of residual film (%) | Image | Resolution of edges | Latitude of development |
|---|---|---|---|---|---|---|---|---|---|
| Example 2 | Dye B2 1 | Dye F2 6 | ⊚ | 180 | 75 | 70 | ⊚ | ⊚ | ⊚ |
| Example 3 | Dye B3 3 | Dye F3 3 | ⊚ | 180 | 75 | 69 | ⊚ | ⊚ | ⊚ |
| Example 4 | Dye B4 4 | Dye F4 4 | ⊚ | 180 | 75 | 72 | ⊚ | ⊚ | ⊚ |
| Example 5 | Dye B5 6 | Dye F1 1 | ⊚ | 180 | 75 | 73 | ⊚ | ⊚ | ⊚ |
| Example 6 | Dye B6 2 | Dye F2 2 | ⊚ | 180 | 75 | 71 | ⊚ | ⊚ | ⊚ |

In Table 4, the dyes B2 to B6 and dyes F2 to F4 are as follows. Each proportion of the components (B) and (F) are shown by parts by weight when the proportion of the component (A) to be compounded is set to 100 parts by weight.
Dye B2: IR-B (manufactured by SHOWA DENKO K.K., infrared absorbing dye represented by the above formula (9)).
Dye B3: IR-T (manufactured by SHOWA DENKO K.K., infrared absorbing dye represented by the above formula (10)).
Dye B4: IR-2MF (manufactured by SHOWA DENKO K.K., infrared absorbing dye represented by the above formula (11)).
Dye B5: IR-13F (manufactured by SHOWA DENKO K.K., infrared absorbing dye represented by the above formula (12)).
Dye B6: NK-2014 (manufactured by Hayashibara biochemical laboratories Inc., infrared absorbing dye represented by the following formula (56)).

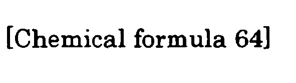

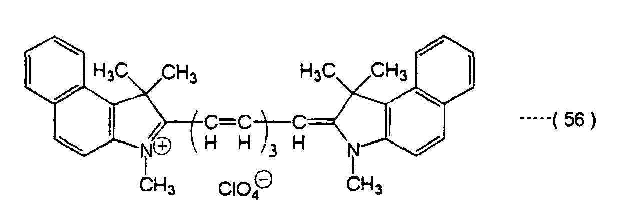

Dye F2: Aizen Methyl Violet BB Special (manufactured by Hodogaya Chemical Co., Ltd., C.I. Basic Violet 1, No. 42535).
Dye F3: Aizen Crystal Violet (manufactured by Hodogaya Chemical Co., Ltd., C.I. Basic Violet 3, No. 42555).
Dye F4: Aizen Victoria Blue BH (manufactured by Hodogaya Chemical Co., Ltd., C.I. Basic Blue 26, No. 44045).

### (Examples 7 to 15)

Experiments were made in the same manner as in Example 1-2 except that the component (A) was altered as shown in Table 5. The results are shown also in Table 5.

**[Table 5]**

| | Component (A) | Adhesion | Sensitivity (mJ/cm²) | Development (seconds) | Rate of residual film (%) | Image | Resolution of edges | Latitude of development |
|---|---|---|---|---|---|---|---|---|
| Example 7 | Resin A2 | ⊚ | 180 | 75 | 73 | ⊚ | ⊚ | ⊚ |
| Example 8 | Resin A3 | ⊚ | 180 | 75 | 72 | ⊚ | ⊚ | ⊚ |
| Example 9 | Resin A4 | ⊚ | 180 | 75 | 75 | ⊚ | ⊚ | ⊚ |
| Example 10 | Resin A5 | ⊚ | 180 | 75 | 70 | ⊚ | ⊚ | ⊚ |
| Example 11 | Resin A6 | ⊚ | 180 | 75 | 72 | ⊚ | ⊚ | ⊚ |
| Example 12 | Resin A7 | ⊚ | 180 | 75 | 69 | ⊚ | ⊚ | ⊚ |
| Example 13 | Resin A8 | ⊚ | 180 | 75 | 73 | ⊚ | ⊚ | ⊚ |
| Example 14 | Resin A9 | ⊚ | 180 | 75 | 72 | ⊚ | ⊚ | ⊚ |
| Example 15 | Resin A10 | ⊚ | 180 | 75 | 71 | ⊚ | ⊚ | ⊚ |

In Table 5, the proportion of the component (A) to be compounded is the same as that used in Example 1 and the resins A2 to A10 are as follows.
Resin A2: SMA 17352 (manufactured by SARTOMER Company, Inc., a partial ester of styrene/maleic anhydride copolymer with isopropanol/cyclohexanol).
Resin A3: SMA 2624 (manufactured by SARTOMER Company, Inc., a partial ester of styrene/maleic anhydride copolymer with *n*-propanol).
Resin A4: SMA 3840 (manufactured by SARTOMER Company, Inc., a partial ester of styrene/maleic anhydride copolymer with isooctanol).
Resin A5: Oxilac SH-101 (Nippon Shokubai Co., Ltd., copolymer of styrene and maleic acid half-ester).
Resin A6: Copolymer of acrylic acid, methyl methacrylate and styrene (acid value: 98, weight average molecular weight: 21000, base monomer ratio: acrylic acid : methyl methacrylate : styrene = 1:1:1).
Resin A7: Maleic acid polymer (acid value: 300, weight-average molecular weight: 10000).
Resin A8: Acrylic acid polymer (acid value: 100, weight-average molecular weight: 25000).
Resin A9: Oxilac SH-101 derivative (styrene/maleic acid copolymer to which glycidyl methacrylate is added, acid value: 80).
Resin A10: Resin A6 to which glycidyl methacrylate is added.

### (Examples 16 to 25)

Experiments were made in the same manner as in Example 1-2 except that each resin shown in Table 6 was used instead of the resin E1 as the component (E). The results are shown also in Table 6.

**[Table 6]**

| Example No. | Component (E) Proportion by weight | Adhesion | Sensitivity (mJ/cm²) | Development (seconds) | Rate of residual film (%) | image | Resolution of edges | Latitude of development |
|---|---|---|---|---|---|---|---|---|
| 16 | Resin E2 2 | ⊚ | 180 | 75 | 69 | ⊚ | ⊚ | ⊚ |
| 17 | Resin E3 5 | ⊚ | 180 | 75 | 73 | ⊚ | ⊚ | ⊚ |
| 18 | Resin E4 10 | ⊚ | 180 | 75 | 75 | ⊚ | ⊚ | ⊚ |
| 19 | Resin E5 8 | ⊚ | 180 | 75 | 72 | ⊚ | ⊚ | ⊚ |
| 20 | Resin E6 20 | ⊚ | 180 | 75 | 70 | ⊚ | ⊚ | ⊚ |
| 21 | Resin E7 30 | ⊚ | 180 | 75 | 71 | ⊚ | ⊚ | ⊚ |
| 22 | Resin E8 10 | ⊚ | 180 | 75 | 77 | ⊚ | ⊚ | ⊚ |
| 23 | Resin E9 10 | ⊚ | 180 | 75 | 76 | ⊚ | ⊚ | ⊚ |
| 24 | Resin E10 10 | ⊚ | 180 | 75 | 73 | ⊚ | ⊚ | ⊚ |
| 25 | Resin E11 8 | ⊚ | 180 | 75 | 75 | ⊚ | ⊚ | ⊚ |

In Table 6, the resins E2 to E11 are as follows.
Resin E2: GAFQUAT 734 (manufactured by ISP Company, vinyl pyrrolidone/dimethylaminoethyl methacrylate copolymer)
Resin E3: GAFFIX VC-713 (manufactured by ISP Company, ter-polymer of vinyl pyrrolidone, vinyl caprolactam and dimethylaminoethyl methacrylate)
Resin E4: Saknohol SN-09T (manufactured by Denki Kagaku Kogyo Kabushiki Kaisha, polyvinyl acetate)
Resin E5: Denka Butyral #3000 (manufactured by Denki Kagaku Kogyo Kabushiki Kaisha, polyvinyl butyral)
Resin E6: Vinylec K type (manufactured by Chisso Corporation, polyvinyl formal)
Resin E7: Tamanol 803L (manufactured by Arakawa Chemical Industries Ltd., terpene phenolic resin)
Resin E8: Tamanol 520S (manufactured by Arakawa Chemical Industries Ltd., alkylphenolic resin)
Resin E9: Bancemine SM-960 (manufactured by Harima Chemicals, Inc., melamine-formaldehyde resin)
Resin E10: Hilac 111 (manufactured by Hitachi Chemical Co., Ltd., cyclohexanone resin)
Resin E11: Hilac 110H (manufactured by Hitachi Chemical Co., Ltd., acetophenone resin)

### (Example 26)

An experiment was made in the same manner as in Example 1-2 except that the component (C) was not compounded. The results are shown in Table 7.

### (Example 27)

An experiment was made in the same manner as in Example 1-2 except that the component (D) was not compounded. The results are shown in Table 7.

### (Example 28)

An experiment was made in the same manner as in Example 1-2 except that the component (E) was not compounded. The results are shown in Table 7.

### (Example 29)

An experiment was made in the same manner as in Example 1-2 except that the components (C), (D) and (E) were not compounded. The results are shown in Table 7.

**[Table 7]**

| Example No. | Adhesion | Sensitivity (mJ/cm²) | Development (seconds) | Rate of residual film (%) | Image | Resolution of edges | Latitude of development |
|---|---|---|---|---|---|---|---|
| 26 | ⊚ | 180 | 75 | 73 | ⊚ | ⊚ | ⊚ |
| 27 | ⊚ | 180 | 75 | 71 | ⊚ | ⊚ | ⊚ |
| 28 | ⊚ | 180 | 75 | 76 | ⊚ | ⊚ | ⊚ |
| 29 | ⊚ | 180 | 75 | 75 | ⊚ | ⊚ | ⊚ |

### (Comparative Examples 1 to 3)

An experiment was made in the same manner as in Example 1-2 except that the combination of the positive photosensitive composition was altered as shown in Table 8. The results are shown in Table 9.

**[Table 8]**

| | | Comparative Example 1 | Comparative Example 2 | Comparative Example 3 |
|---|---|---|---|---|
| Novolak A1 | | 100 | 100 | 100 |
| IR-photosensitive dye B1 | | 1 | 1 | 1 |
| Organotitanium compound | | - | 2 | - |
| Imidazole silane | | - | - | 2 |
| Solvent | PM | 800 | 800 | 800 |
| | IPA | 800 | 800 | 800 |
| | MEK | 600 | 600 | 600 |

In Table 8, the IR-photosensitive dye B1 and the solvent are the same as those shown in Table 1 and other components are as follows.
Novolak resin: PR-NMD-100 (manufactured by Sumitomo Bakelite Co., Ltd.)
Organotitanium compound: Orgatics TA-10 (titanium alkoxide) manufactured by Matsumoto Chemical Industry Co., Ltd.
Imidazole silane: Silane coupling agent having the structure represented by the following formula (57). In the formula (57), R⁴¹ to R⁴⁴ respectively represent an alkyl group and "n" denotes an integer of 1 to 3.

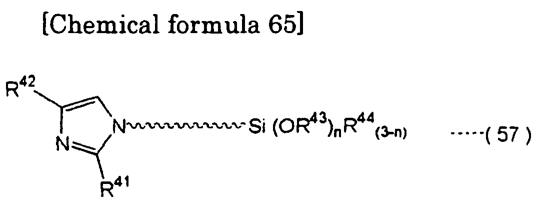

**[Table 9]**

| | Adhesion | Sensitivity (mJ/cm²) | Development (seconds) | Rate of residual film (%) | Image | Resolution of edges | Latitude of development |
|---|---|---|---|---|---|---|---|
| Comparative Example 1 | O | 150 | 60 | 0 | - | × | × |
| Comparative Example 2 | O | 150 | 60 | 0 | - | × | × |
| Comparative Example 3 | O | 150 | 60 | 0 | - | × | × |

In Comparative Examples 1 to 3 as shown in Table 9, the image disappeared after development and no latitude of development was obtained at all.

### Capability of Exploitation in Industry:

The positive photosensitive composition of the present invention is preferably used to form a positive photosensitive film on the copper sulfate surface of a plate-making roll for gravure printing. However, no particular limitation to the material on which the composition of the present invention is applied. Even if the composition is applied to plates of metals such as aluminum, zinc and steel, metal plates on which aluminum, zinc, copper, iron, chromium, nickel, or the like is plated or deposited, paper coated with a resin, paper coated with a metal foil such as an aluminum foil, plastic films, hydrophilically treated plastic films, glass plates, and so on, it has high adhesion at low temperatures, ensuring that high sensitivity is obtained.

The positive photosensitive composition of the present invention is, therefore, preferably used for photosensitive planographic printing plates, proofs for simplified proofing printing, wiring boards, gravure copper etching resists, color-filter resists used to produce flat displays, photoresists for producing LSI and the like.

## Claims

1. A positive photosensitive composition comprising:
(A) a high molecular substance having at least one carboxyl group in a molecule and
(B) a photo-thermal conversion material that absorbs infrared ray from an image exposure light source and converts it to heat, wherein the high molecular substance (A) is a polymer represented by the following formula (1): 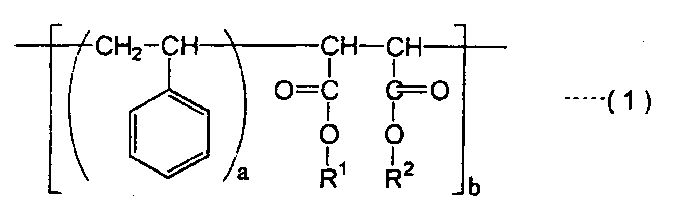
wherein each of "R¹" and "R² " independently represents a hydrogen atom or a substituted or unsubstituted alkyl group, "a" denotes an integer from 1 to 3 and "b" denotes an integer of 1 or more.

2. The positive photosensitive composition according to claim 1, the composition further comprising (C) a dissolution inhibitor.

3. The positive photosensitive composition according to claim 2, wherein the dissolution inhibitor (C) is a compound represented by the following chemical formula (2):

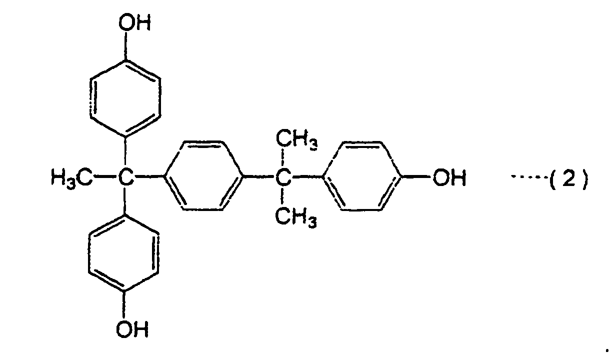

4. The positive photosensitive composition according to any of claims 1 to 3, wherein the photo-thermal conversion material (B) is a compound represented by the following formula (3): 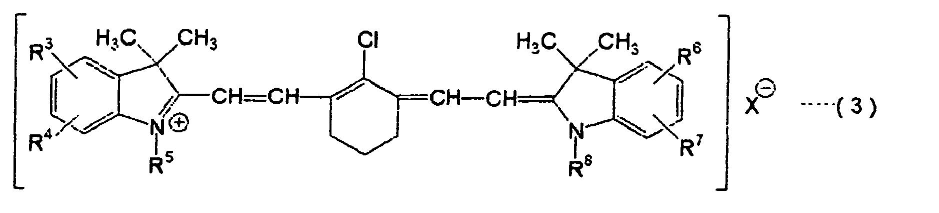 wherein each of "R³" to "R⁸" independently represents a hydrogen atom, an alkyl group having 1 to 3 carbon atoms or an alkoxyl group having 1 to 3 carbon atoms, "X" represents a halogen atom, ClO₄, BF₄, p-CH₃C₆H₄SO₃ or PF₆.

5. The positive photosensitive composition according to any of claims 1 to 4, wherein the photo-thermal conversion material (B) is a compound represented by the following formula (4): 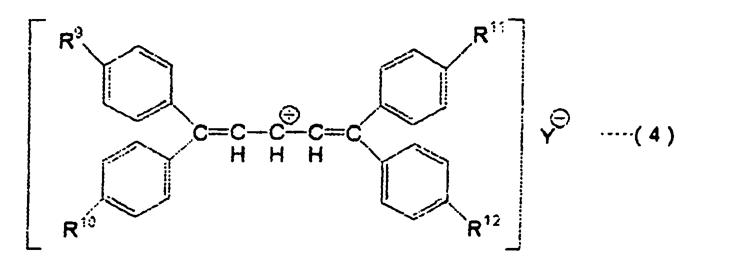 wherein each of "R⁹" to "R¹²" independently represents a hydrogen atom, a methoxyl group, -N(CH₃)₂ or -N(C₂H₅)₂ and "Y" represents C₄H₉-B(C₆H₅)₃, *p*-CH₃C₆H₄SO₃ or CF₃SO₃.

6. The positive photosensitive composition according to any of claims 1 to 5, the composition further comprising (D) a photo-acid generator.

7. The positive photosensitive composition according to claim 6, wherein the photo-acid generator (D) is a compound represented by the following formula (5):

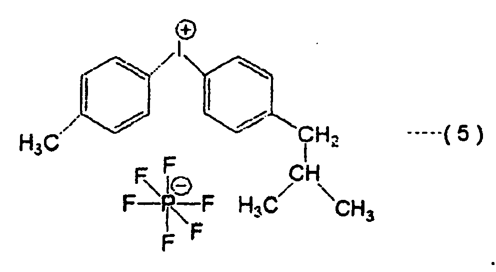

8. The positive photosensitive composition according to any of claims 1 to 7, the composition further comprising (E) at least one resin selected from the group consisting of (1) a vinylpyrrolidone/vinyl acetate copolymer, (2) a vinylpyrrolidone/dimethylaminoethyl methacrylate copolymer; (3) a vinylpyrrolidone/vinyl caprolactam/dimethylaminoethyl methacrylate copolymer, (4) a polyvinyl acetate, (5) a polyvinyl butyral, (6) a polyvinyl formal, (7) a terpene phenolic resin, (8) an alkylphenolic resin, (9) a melamine-formaldehyde resin and (10) a ketone resin.

9. The positive photosensitive composition according to any of claims 1 to 8, the composition further comprising (F) a triarylmethane dye.

10. A photo-fabrication method using the positive photosensitive composition according to any of claims 1 to 9,

11. The photo-fabrication method according to claim 10, which is applied to production of a printing plate, an electronic component, a precision equipment component and a component relating to a counterfeit deterrence.

12. A plate-making method using the positive photosensitive composition according to any of claims 1 to 11.

## Patentansprüche

1. Positive lichtempfindliche Zusammensetzung umfassend:
(A) eine hochmolekulare Substanz mit wenigstens einer Carboxylgruppe in einem Molekül und
(B) ein fotothermisches Umwandlungsmaterial, welches Infrarot-Strahlen von einer Lichtquelle zur Bildbelichtung absorbiert und in Wärme umwandelt, wobei die hochmolekulare Substanz (A) ein Polymer ist, das durch die folgende Formel (1) wiedergegeben wird: 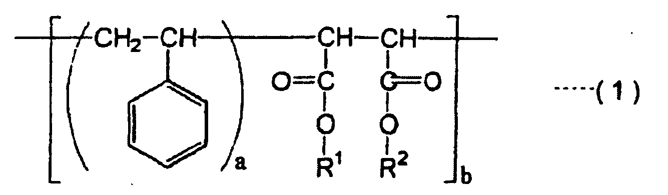 worin jedes von "R¹" und "R²" unabhängig voneinander ein Wasserstoffatom oder eine substituierte oder unsubstituierte Alkylgruppe bedeutet, "a" eine ganze Zahl von 1 bis 3 bedeutet und "b" eine ganze Zahl von 1 oder mehr bedeutet.

2. Positive lichtempfindliche Zusammensetzung nach Anspruch 1, wobei die Zusammensetzung außerdem (C) einen Auflösungsinhibitor umfasst.

3. Positive lichtempfindliche Zusammensetzung nach Anspruch 2, wobei der Auflösungsinhibitor (C) eine Verbindung ist, die durch die folgende chemische Formel (2) wiedergegeben wird:

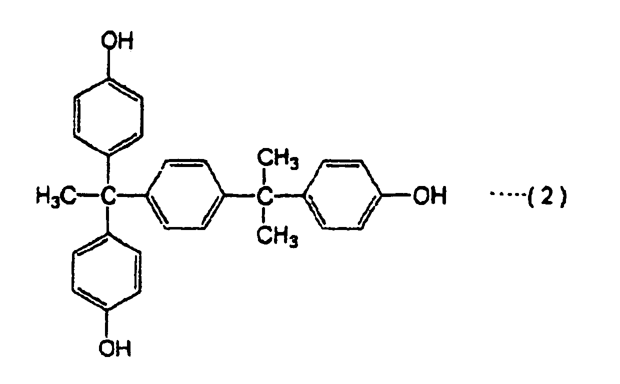

4. Positive lichtempfindliche Zusammensetzung nach einem der Ansprüche 1 bis 3, wobei das fotothermische Umwandlungsmaterial (B) eine Verbindung ist, die durch die folgende Formel (3) wiedergegeben wird: 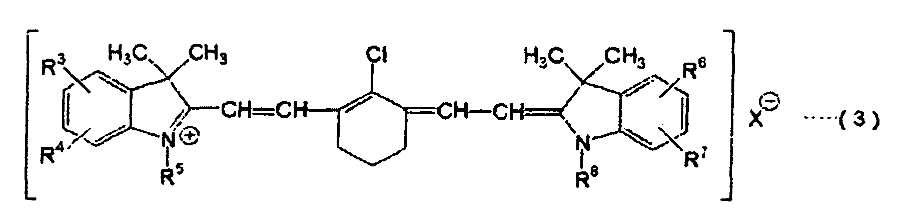 wobei jedes von "R³" bis "R⁸" unabhängig voneinander ein Wasserstoffatom, eine Alkylgruppe mit 1 bis 3 Kohlenstoffatomen oder eine Alkoxylgruppe mit 1 bis 3 Kohlenstoffatomen bedeutet, "X" ein Halogenatom, ClO₄, BF₄, p-CH₃C₆H₄SO₃ oder PF₆ bedeutet.

5. Positive lichtempfindliche Zusammensetzung nach einem der Ansprüche 1 bis 4, wobei das fotothermische Umwandlungsmaterial (B) eine Verbindung ist, die durch die folgende Formel (4) wiedergeben wird: 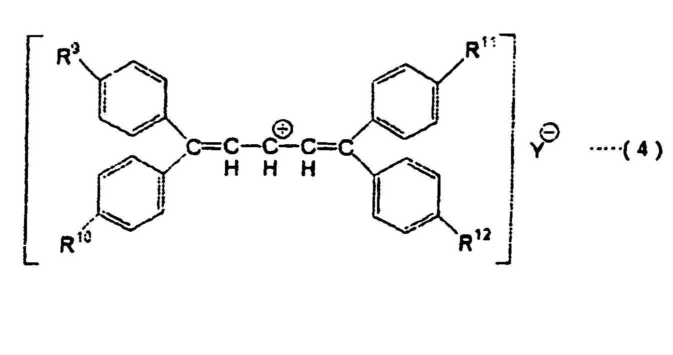 worin jedes von "R⁹" bis "R¹²" unabhängig voneinander ein Wasserstoffatom, eine Methoxylgruppe, -N(CH₃)₂ oder -N(C₂H₅)₂ bedeutet und "Y" C₄H₉-B(C₆H5)₃, p-CH₃C₆H₄SO₃ oder CF₃SO₃ bedeutet.

6. Positive lichtempfindliche Zusammensetzung nach einem der Ansprüche 1 bis 5, wobei die Zusammensetzung außerdem (D) einen Fotosäuregenerator umfasst.

7. Positive lichtempfindliche Zusammensetzung nach Anspruch 6, wobei der Fotosäuregenerator (D) eine Verbindung ist, die durch die folgende Formel (5) wiedergegeben wird:

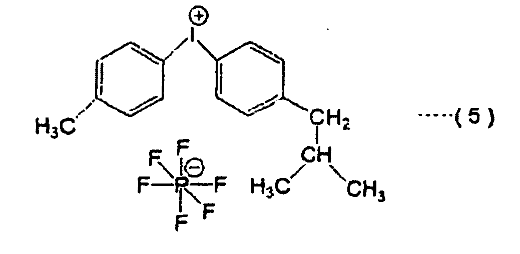

8. Positive lichtempfindliche Zusammensetzung nach einem der Ansprüche 1 bis 7, wobei die Zusammensetzung außerdem (E) wenigstens ein Harz umfasst, das ausgewählt ist aus der Gruppe bestehend aus (1) einem Vinylpyrrolidon/Vinylacetat-Copolymer, (2) einem Vinylpyrrolidon/Dimethylaminoethylmethacrylat-Copolymer, (3) einem Vinylpyrrolidon/Vinylcaprolactam/Dimethylaminoethylmethacrylat-Copolymer, (4) einem Polyvinylacetat, (5) einem Polyvinylbutyral, (6) einem Polyvinylformal, (7) einem Terpenphenolharz, (8) einem Alkylphenolharz, (9) einem Melamin-Formaldehydharz und (10) einem Ketonharz.

9. Positive lichtempfindliche Zusammensetzung nach einem der Ansprüche 1 bis 8, wobei die Zusammensetzung außerdem (F) einen Triarylmethanfarbstoff umfasst.

10. Fotografisches Herstellungsverfahren unter Verwendung der positiven lichtempfindlichen Zusammensetzung nach einem der Ansprüche 1 bis 9.

11. Fotografisches Herstellungsverfahren nach Anspruch 10, welches auf die Herstellung einer Druckplatte, einer elektronischen Komponente, einer Präzisionsanlagenkomponente und einer Komponente, die sich auf die Verhinderung von Fälschungen bezieht, angewandt wird.

12. Plattenherstellungsverfahren unter Verwendung der positiven lichtempfindlichen Zusammensetzung nach einem der Ansprüche 1 bis 11.

## Revendications

1. Composition photosensible positive, comprenant :
(A) une substance de poids moléculaire élevé ayant au moins un groupe carboxyle dans une molécule, et
(B) un matériau de conversion photo-thermique qui absorbe les rayons infrarouges d'une source de lumière d'exposition d'une image et les convertit en chaleur, la substance de poids moléculaire élevée (A) étant un polymère représenté par la formule (1) suivante : 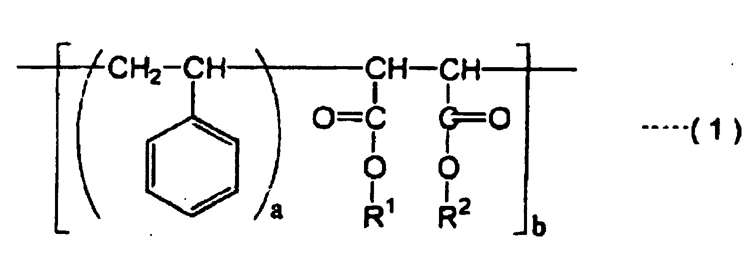 dans laquelle chacun des radicaux « R¹ » et « R² » représente indépendamment, un atome d'hydrogène ou un groupe alkyle substitué ou non substitué, « a » désigne un nombre entier de 1 à 3 et « b » désigne un nombre entier de 1 ou plus.

2. Composition photosensible positive selon la revendication 1, la composition comprenant en outre (C) un inhibiteur de dissolution.

3. Composition photosensible positive selon la revendication 2, dans laquelle l'inhibiteur de dissolution (C) est un composé représenté par la formule chimique (2) suivante :

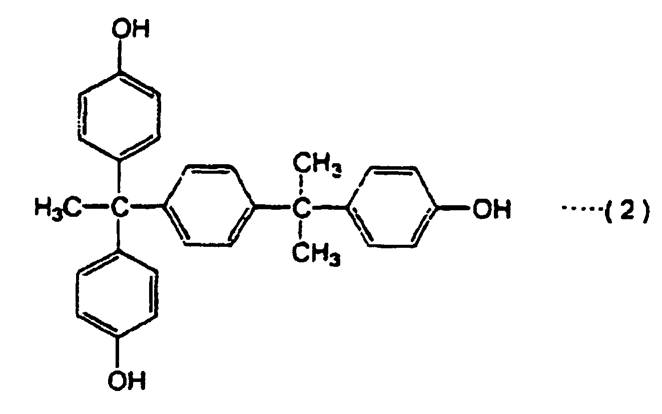

4. Composition photosensible positive selon l'une quelconque des revendications 1 à 3, dans laquelle le matériau de conversion photo-thermique (B) est un composé représenté par la formule suivante (3) : 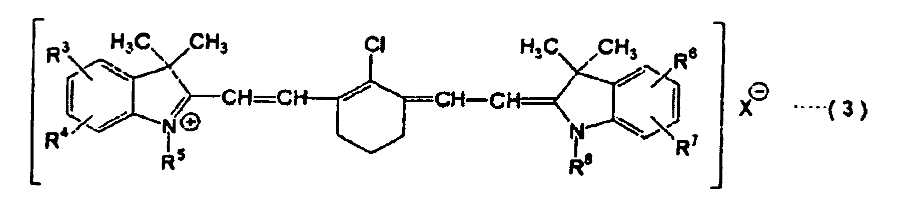 dans laquelle chacun des radicaux « R³ » à « R⁸ » représente indépendamment un atome d'hydrogène, un groupe alkyle ayant de 1 à 3 atomes de carbone ou un groupe alcoxyle ayant de 1 à 3 atomes de carbone, « X » représente un atome d'halogène, C10₄, BF₄, *p*-CH₃C₆H₄SO₃ ou PF₆ .

5. Composition photosensible positive selon l'une quelconque des revendications 1 à 4, dans laquelle le matériau de conversion photo-thermique (B) est un composé représenté par la formule (4) suivante : 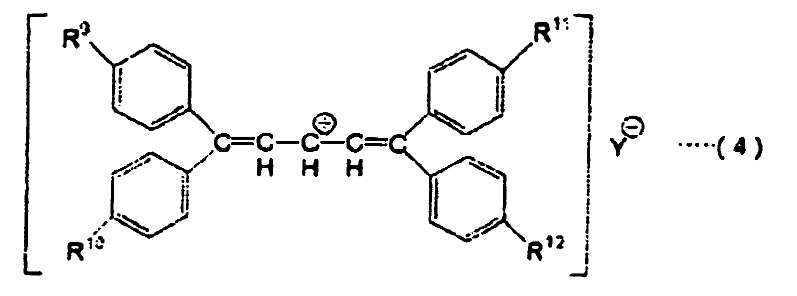 dans laquelle chacun des radicaux « R⁹ » à « R¹² » représente indépendamment un atome d'hydrogène, un groupe méthoxyle, -N(CH₃)₂ ou -N(C₂H₅)₂ et « Y » représente C₄H₉-B (C₆H₅) ₃, P-CH₃C₆H₄SO₃ ou CF₃SO₃ .

6. Composition photosensible positive selon l'une quelconque des revendications 1 à 5, la composition comprenant en outre (D) un générateur photo-acide.

7. Composition photosensible positive selon la revendication 6, dans laquelle le générateur photo-acide (D) est un composé représenté par la formule suivante (5) :

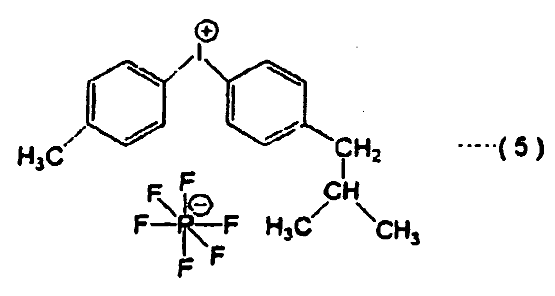

8. Composition photosensible positive selon l'une quelconque des revendications 1 à 7, la composition comprenant en outre (E) au moins une résine choisie dans le groupe comprenant (1) un copolymère de vinylpyrrolidone/acétate de vinyle, (2) un copolymère de vinylpyrrolidone/diméthylamino-éthyl-méthacrylate, (3) un copolymère de vinylpyrrolidone/vinyl-caprolactame/diméthylamino-éthyl-méthacrylate, (4) un acétate de polyvinyle, (5) un polyvinyl-butyral, (6) un polyvinylformal, (7) une résine terpène phénolique, (8) une résine alkylphénolique, (9) une résine mélamine-formaldéhyde et (10) une résine cétone.

9. Composition photosensible positive selon l'une quelconque des revendications 1 à 8, la composition comprenant en outre (F) un colorant triarylméthane.

10. Procédé de photo-fabrication utilisant la composition photosensible positive selon l'une quelconque des revendications 1 à 9.

11. Procédé de photo-fabrication selon la revendication 10, qui est appliqué à la production d'une plaque d'impression, d'un composant électronique, d'un composant d'équipement de précision et d'un composant concernant la dissuasion de la contrefaçon.

12. Procédé de fabrication de plaque utilisant la composition photosensible positive selon l'une quelconque des revendications 1 à 11.
